# EUROPEAN PATENT APPLICATION

(11) **EP 4 632 326 A1**
(43) Date of publication of application: **15.10.2025**
(21) Application number: 25157329.1
(22) Date of filing: 12.02.2025
(51) Int. Cl.: G01C 21/36, G06F 30/15, G06F 11/30

(54) **THREE-DIMENSIONAL MODEL AUGMENTATION FOR AN AERIAL VEHICLE BASED ON REAL-TIME TELEMETRY DATA AND MANIFEST DATA FOR THE AERIAL VEHICLE**

(30) Priority: 23.02.2024 IN 202411013076; 13.08.2024 US 202418801982
(71) Applicant: Honeywell International Inc., Charlotte, NC 28202 (US)
(72) Inventor: KOTHANDARAMAN, Deena Dayalan, Charlotte, 28202 (US); PAUL, Paulson, Charlotte, 28202 (US); AVERKOVA, Dariia, Charlotte, 28202 (US); GUDINO, Roberto, Charlotte, 28202 (US); THAWANI, Yash Lakhmichand, Charlotte, 28202 (US)
(74) Representative: Haseltine Lake Kempner LLP

(57) **Abstract**

Embodiments of the present disclosure are directed to providing three-dimensional (3D) model augmentation for a vehicle. In an example embodiment, a manifest data structure and 3D model for a vehicle communicatively coupled to a control station (CS) system is received. The manifest data structure includes a parameterized format for respective sub-components of the vehicle that links telemetry parameters to respective portions of the 3D model for the vehicle. Based on the manifest data structure for the vehicle, real-time telemetry data is correlated with the respective portions of the 3D model to generate a visually augmented version of the 3D model for the vehicle.

## Description

### CROSS REFERENCE TO RELATED APPLICATIONS

This application claims priority to India Provisional Patent Application No. 202411013076 filed on February 23, 2024, the entirety of which is hereby incorporated by reference.

### TECHNICAL FIELD

Embodiments of the present disclosure generally relate to safely managing a flight plan associated with the operation of an aerial vehicle, and more specifically to generating communications and/or control signals for an aerial vehicle that are characterized by an emergency flight path for the aerial vehicle or one or more other aerial vehicles.

### BACKGROUND

As the aerospace industry continues to deploy more aerial vehicles, it is desirable for the aerial vehicles are able to increasingly operate in an autonomous flight mode. However, there are multiple factors that can impact the efficiency, safety, and/or operation of an aerial vehicle during an autonomous flight mode. In general, various sensors, monitors, and systems associated with the electric aerial vehicle may provide raw data related to particular operational components of the aerial vehicle to provide situational awareness, contextual information, and/or other useful data for the aerial vehicle. However, the inventors have discovered various problems with current autonomous flight techniques related to aerial vehicles. Through applied effort, ingenuity, and innovation, the inventors have solved many of these problems by developing the solutions embodied in the present disclosure, the details of which are described further herein.

### BRIEF SUMMARY

In general, embodiments of the present disclosure herein provide autonomous protected flight zones during emergency operations of aerial vehicles. Other implementations will be, or will become, apparent to one with skill in the art upon examination of the following figures and detailed description. It is intended that all such additional implementations be included within this description be within the scope of the disclosure and be protected within the scope of the following claims.

In an embodiment, a computer-implemented method is provided. The computer-implemented method is performable by one or more specially configured computing device(s) embodied in hardware, software, firmware, and/or any combination thereof, for example as described herein. In one or more embodiments, the computer-implemented method includes receiving (i) a manifest data structure and (ii) a three-dimensional (3D) model for a vehicle communicatively coupled to a control station (CS) system, wherein the manifest data structure comprises a parameterized format for respective sub-components of the vehicle that links telemetry parameters to respective portions of the 3D model for the vehicle. In one or more embodiments, the computer-implemented method additionally or alternatively includes correlating real-time telemetry data with the respective portions of the 3D model based on the manifest data structure for the vehicle. In one or more embodiments, the computer-implemented method additionally or alternatively includes generating a visually augmented version of the 3D model for the vehicle based on the real-time telemetry data correlated with the respective portions of the 3D model. In one or more embodiments, the visually augmented version of the 3D model emphasizes at least one particular respective portion of the 3D model based on the real-time telemetry data. In one or more embodiments, the visually augmented version of the 3D model provides dynamic visual indicators that alter depiction of the respective sub-components of the vehicle based on the real-time telemetry data. In one or more embodiments, the computer-implemented method additionally or alternatively includes causing a rendering of the visually augmented version of the 3D model via a display of the CS system.

In one or more embodiments, the computer-implemented method additionally or alternatively includes receiving the manifest data structure in response to establishment of a communication connection between the vehicle and the CS system.

In one or more embodiments, the computer-implemented method additionally or alternatively includes receiving an encoded version of the 3D model from the vehicle in response to establishment of a communication connection between the vehicle and the CS system.

In one or more embodiments, the computer-implemented method additionally or alternatively includes receiving (i) the manifest data structure and (ii) an encoded version of the 3D model from the vehicle in response to establishment of a communication connection between the vehicle and the CS system.

In one or more embodiments, receiving the manifest data structure includes receiving the manifest data structure from the vehicle in response to establishment of a communication connection between the vehicle and the CS system.

In one or more embodiments, receiving the 3D model includes receiving the 3D model from the vehicle in response to establishment of a communication connection between the vehicle and the CS system.

In one or more embodiments, receiving the 3D model includes extracting the 3D model from a datastore communicatively coupled to the CS system based on a vehicle identifier associated with the vehicle.

In one or more embodiments, the computer-implemented method additionally or alternatively includes initially receiving a first version of the 3D model associated with a particular degree of fidelity based on datalink bandwidth conditions between the CS system and the vehicle. In one or more embodiments, the computer-implemented method additionally or alternatively includes subsequently receiving a second version of the 3D model with a higher degree of fidelity in response to a certain degree of increase for the datalink bandwidth availability between the CS system and the vehicle.

In one or more embodiments, the visually augmented version of the 3D model provides the dynamic visual indicators as a particular color change, a highlight, a glow, and/or an icon that alters depiction of the respective sub-components of the vehicle based on the real-time telemetry data.

In one or more embodiments, the vehicle is an aerial vehicle communicatively coupled to the CS system via a wireless communication channel.

In another embodiment, an apparatus is provided. In one or more embodiments, the apparatus includes at least one processor and at least one memory having computer-coded instructions stored thereon, where the computer-coded instructions in execution with the at least one processor causes the apparatus to perform any one of the example computer-implemented methods described herein. In one or more embodiments, the apparatus includes means for performing each step of any one of the example computer-implemented methods described herein.

In yet another embodiment, a computer program product is provided. In one or more embodiments, the computer program product includes at least one non-transitory computer-readable storage medium having computer program code stored thereon that, in execution with at least one processor, configures the computer program product for performing any one of the example computer-implemented methods described herein.

### BRIEF DESCRIPTION OF THE SEVERAL VIEWS OF THE DRAWINGS

To easily identify the discussion of any particular element or act, the most significant digit or digits in a reference number refer to the figure number in which that element is first introduced.
FIG. 1 illustrates an example system that provides three-dimensional (3D) model augmentation for an aerial vehicle in accordance with one or more embodiments of the present disclosure;
FIG. 2 illustrates an example control station apparatus in accordance with one or more embodiments of the present disclosure;
FIG. 3 illustrates an example vehicle apparatus in accordance with one or more embodiments of the present disclosure;
FIG. 4 illustrates an example flight management platform in accordance with one or more embodiments of the present disclosure;
FIG. 5 illustrates an example system configured for 3D model augmentation related to an aerial vehicle in accordance with one or more embodiments of the present disclosure;
FIG. 6 illustrates an operational example of an electronic display configured to display one or more interface elements in accordance with one or more embodiments of the present disclosure;
FIG. 7 illustrates an example manifest data structure in accordance with one or more embodiments of the present disclosure;
FIG. 8 illustrates example 3D model data in accordance with one or more embodiments of the present disclosure; and
FIG. 9 illustrates a flowchart depicting example operations of an example process for providing augmentation of a 3D model augmentation for an aerial vehicle in accordance with one or more embodiments of the present disclosure.

### DETAILED DESCRIPTION

Embodiments of the present disclosure now will be described more fully hereinafter with reference to the accompanying drawings, in which some, but not all, embodiments of the disclosure are shown. Indeed, embodiments of the disclosure may be embodied in many different forms and should not be construed as limited to the embodiments set forth herein, rather, these embodiments are provided so that this disclosure will satisfy applicable legal requirements. Like numbers refer to like elements throughout.

### OVERVIEW

As the various branches of the transportation industry move ever towards semi-autonomously and autonomously controlled aerial vehicles, operators, pilots, drivers, and/or control systems associated with respective aerial vehicles may have further limited knowledge and/or limited experience with which to make crucial decisions regarding one or more adverse situations impacting the operation of the aerial vehicle. In this regard, the cognitive workload for a human to gain a complete situational and/or vehicle system status awareness based at least in part on disparate data coming from a multitude of sources remains high or even may increase, and, in some circumstances, it is difficult or impossible for a human to make an accurate decision and perform a corresponding action based at least in part on the many nuances of a given, often time-sensitive, situation. Additionally, typical monitoring systems for aerial vehicles merely display synoptics for the aerial vehicles via a two-dimensional (2D) visualization.

However, in scenarios in which the semi-autonomously and autonomously controlled aerial vehicles are exposed to emergency situations, it becomes critical that the operators, pilots, drivers, control systems, monitoring systems, and/or surveillance systems associated with respective aerial vehicles understand risks and/or a real-time status for the aerial vehicle. For example, consider a scenario where a semi-autonomously or autonomously controlled aerial vehicle encounters a scenario in which one or more components of the aerial vehicle are unable to meet an operational intent due to a failure. In such a scenario, the aerial vehicle may be forced to land, and may result in undesirable inefficiencies and/or damage to the aerial vehicle. Moreover, manual communications, instructions, and/or actions to rectify operation of the one or more components can result in added delays and/or errors for the aerial vehicle, resulting in additional inefficiencies for a control system and/or overall system for the aerial vehicle.

Embodiments of the present disclosure are configured to address the limitations of traditional vehicle management systems by providing three-dimensional (3D) model augmentation for an aerial vehicle based on real-time telemetry data and/or manifest data for the aerial vehicle. The telemetry data can include real-time data related to the aerial vehicle such as, but not limited to flight parameters, vehicle component parameters, system parameters, flight control parameters, engine parameters, sensor data, navigation data, vehicle health monitoring data, and/or other real-time data related to the aerial vehicle. The manifest data can include parameterized data for respective vehicle components of the aerial vehicle that links the telemetry data to respective portions of a 3D model for the aerial vehicle. Based on the real-time telemetry data correlated with the respective portions of the 3D model, a visually augmented version of the 3D model for the aerial vehicle can then be generated. As such, a visual 3D representation of the aerial vehicle can be provided for one or more systems such as, for example, a control station (CS) system, a ground control system, a flight management platform, a vehicle traffic management system, a remote operations center, an aerial vehicle system, an aerial vehicle board system, an electronic display, and/or another type of system.

In various embodiments, the visualization of the 3D representation of the aerial vehicle can highlight vehicle components of interest via the 3D model. Additionally or alternatively, the real-time telemetry data can be parametrically associated with the 3D model via a standardized framework for the aerial vehicle representation in 3D by utilizing the manifest data. For example, the visually augmented version of the 3D model can emphasize at least one particular respective portion of the 3D model based on the real-time telemetry data. Additionally, the visually augmented version of the 3D model can provide dynamic visual indicators that alter depiction of the respective vehicle components of the aerial vehicle based on the real-time telemetry data. Moreover, to facilitate the visually augmented version of the 3D model for the aerial vehicle, 3D model data such as, for example, the manifest data for the aerial vehicle, can be encoded as part of an aircraft avionic communication protocol (e.g., an aerial vehicle communication transmission) associated with transponders and/or other communication systems connected to a datalink between the aerial vehicle and a CS system. As such, an interactive 3D visualization of an aerial vehicle integrated with real-time telemetry data and/or system status data can be provided for improved situational awareness and/or vehicle system status awareness for the aerial vehicle.

As such, by utilizing a visually augmented version of a 3D model for an aerial vehicle autonomous as disclosed herein, dynamic, cooperative, and/or safe traffic management for aerial vehicles can be provided. Additionally, by utilizing a visually augmented version of a 3D model for an aerial vehicle autonomous as disclosed herein, efficiency of aerial vehicles and/or related systems can be improved while also mitigating damage to the aerial vehicles. One or more adverse situations for aerial vehicles can also be mitigated by utilizing by utilizing a visually augmented version of a 3D model for an aerial vehicle autonomous as disclosed herein. Additionally, by utilizing a visually augmented version of a 3D model for an aerial vehicle autonomous as disclosed herein, a number of computational resources needed by an aerial vehicle may be advantageously reduced. Power consumption by an aerial vehicle can therefore also be reduced. Moreover, processing efficiency for a control system of an aerial vehicle may be improved and/or damage to an aerial vehicle may be mitigated by utilizing a visually augmented version of a 3D model for an aerial vehicle autonomous as disclosed herein.

It will be appreciated that embodiments of the present disclosure may be advantageous for a myriad of vehicle types. In this regard, aerial vehicles are utilized as an exemplary type of vehicle for purposes of simplifying the disclosure. The description specific to aerial vehicles should not limit the scope and spirit of the disclosure unless otherwise explicitly stated. For example, the systems, techniques, and/or methods described herein may be applicable to the fields of autonomous aircraft operation, autonomous automobile operation, autonomous watercraft operation, autonomous spacecraft operation, other vehicle operation, and/or the like.

### DEFINITIONS

In one or more embodiments, the term "flight management platform" refers to a vehicle platform or module configured to provide a visually augmented version of a 3D model for an aerial vehicle as disclosed herein. A flight management platform can identify and/or mitigate one or more adverse situations related to operation of a vehicle and/or operation of sub-components of a vehicle that can impact the operation of the one or more vehicles. For example, one or more components of the flight management platform can be configured to generate a visually augmented version of a 3D model for a vehicle as disclosed herein by employing real-time telemetry data and manifest data related to the vehicle. Additionally or alternatively, one or more components of the flight management platform can be configured to render the visually augmented version of a 3D model via a display of a control station, a vehicle, and/or another system. A flight management platform in some embodiments is associated with one or more systems such as, for example, a control station system, a logistics system, a delivery and shipment system, a commercial airline system, an aerial delivery system, an urban air mobility (UAM) system, an advanced air mobility (AAM) system, and/or the like that manages and/or deploys a fleet of vehicles. The flight management in some embodiments includes and/or integrates with one or more system(s), computing device(s), service(s), machine learning model(s), and/or datastore(s). For example, the flight management can interface with one or more vehicle operation management system(s), environment data system(s), air traffic control system(s), UAM systems, and/or the like.

In one or more embodiments, the term "onboard flight management system" refers to hardware, software, firmware, and/or a combination thereof, that embodies and/or maintains an application instance configured to integrate with one or more vehicle systems and/or apparatuses associated with a vehicle to provide a visually augmented version of a 3D model for a vehicle. The onboard flight management system comprises, and/or integrates with, among other components, a manifest system, a vehicle monitoring system, a datalink system, and/or one or more electronic displays. The onboard flight management system can be configured to transmit and/or receive data related to the operation and/or emergency conditions related to one or more vehicles via a communications network. Additionally or alternatively, the onboard flight management system can be configured to transmit and/or receive data related to 3D model data and/or manifest data for an vehicle via a communications network. In this regard, the onboard flight management system in some embodiments generates, transmits and/or receives data including, but not limited to, real-time telemetry data, manifest data, emergency flight plan data, vehicle operation management data, vehicle data, environmental data, logistics data, hazard data, air traffic data, road traffic data, and/or the like.

In one or more embodiments, the term "adverse situation" refers to a data-driven determination or characteristic of an effect or operational state of a vehicle, vehicle subsystem, vehicle component, and/or vehicle sub-component. For instance, an adverse situation in some embodiments is a vehicle condition impacting the operation of the vehicle and/or one or more persons associated with the vehicle. An adverse situation in some embodiments can also be a circumstance affecting the optimization of one or more vehicle systems associated with the vehicle (e.g., a battery system, a control system, or the like). A few non-limiting examples of adverse situation types that in some embodiments is associated with a respective adverse situation include, a component failure situation type, an emergency situation type, a hazard situation type, a mechanical failure situation type, a logistical situation type, an environmental situation type, an optimization situation type, a vehicle damage situation type, and/or the like. Determination of an adverse situation in some embodiments is based in part on one or more portions of vehicle performance data. In some embodiments, an onboard flight management system can be configured to identify, classify, categorize, and/or analyze one or more adverse situations impacting the operation of a vehicle to facilitate generation of a 3D protected zone and/or other emergency flight plan data.

In one or more embodiments, the term "telemetry data" refers to data indicative of an operational state of a vehicle or a particular subsystem thereof. Telemetry data can comprise data collected, measured, obtained, generated, and/or otherwise processed by the one or more vehicle component(s) associated with the vehicle. In various embodiments, the telemetry data can comprise real-time data associated with the vehicle and/or one or more vehicle component(s) of the vehicle. In various embodiments, at least a portion of the telemetry data is based at least in part on vehicle sensor data collected, measured, calculated, and/or otherwise generated by one or more sensors associated with the vehicle. Additionally or alternatively, in various embodiments, telemetry data can include at least one data value indicating whether a vehicle is operating in a normal scenario, data indicative of an emergency scenario, data indicative of a hazard scenario, data indicative of a logistical scenario that alters the performance of the vehicle, and/or data indicative of a change in the operation of a component affecting operation of the vehicle. In various embodiments, the telemetry data includes flight parameters, vehicle component parameters, system parameters, flight control parameters, engine parameters, sensor data, navigation data, vehicle health monitoring data, and/or other real-time data related to a vehicle. The flight parameters can include, but is not limited to, altitude, speed, direction, pitch, roll, yaw, and/or one or more other parameters associated with flight of a vehicle. The vehicle component parameters can include measurements, temperature, voltage, current, power, pressure, sensor readings, status indicators, and/or one or more other parameters associated with a component or sub-component of a vehicle.

In one or more embodiments, the term "vehicle sensor data" refers to electronically managed data utilized by a vehicle or component of a vehicle for operation that is captured by at least one sensor onboard or otherwise communicable with the vehicle. Vehicle sensor data in some embodiments is any data collected, measured, calculated, and/or otherwise generated by one or more sensors associated with the vehicle and/or one or more components of the vehicle.

In one or more embodiments, the term "performance monitor" refers to an ML model that is specially configured to receive one or more portions of telemetry data and, based at least in part on the one or more portions of telemetry data, generate one or more portions of vehicle performance data describing one or more operational states of the vehicle. Additionally, the performance monitor can be associated with an onboard flight management system and/or can be configured to identify, classify, categorize, and/or analyze one or more adverse situations impacting the operation of a vehicle.

In one or more embodiments, the term "manifest data structure" refers to data indicative of a parameterization of respective sub-components of a vehicle. For example, a manifest data structure can include a parameterized format for respective sub-components of a vehicle that links telemetry parameters to respective portions of the 3D model for the vehicle. In various embodiments, a manifest data structure can correspond to a manifest file that associates sub-components of a vehicle to 3D elements of a 3D model. In various embodiments, a manifest data structure can include a vehicle identifier, a component identifier, a 3D model portion identifier, a vehicle name, a component name, a component classification, metadata, component hierarchy information, one or more telemetry data identifiers, and/or other parameterization information for respective sub-components of a vehicle.

In one or more embodiments, the term "3D model" refers to a digitally-generated representation of a vehicle in a 3D space. For example, the 3D model can be a digital twin model for a vehicle that digitally represents that vehicle in 3D. In various embodiments, the 3D model can provide a digitally-generated 3D representation of one or more components of the vehicle. Additionally, in various embodiments, the 3D model can be visually augmented based on real-time telemetry data correlated with the respective portions of the 3D model. For example, the 3D model can provide dynamic visual indicators that alter depiction of the respective components of the vehicle based on the real-time telemetry data. The dynamic visual indicators can include, for example, a particular color change, a highlight, a glow, an icon, and/or another visual indicator that alters depiction of the respective components of the vehicle based on the real-time telemetry data. In various embodiments, the 3D model can be displayed via an electronic display associated with one or more respective computing devices (e.g., a display of a control station system, a display of a vehicle, a flight display of an aerial vehicle, etc.).

In one or more embodiments, the term "flight plan" refers to one or more portions of data related to at least one or more destinations, waypoints, flight paths, arrival/departure schedules and/or procedures, routes, missions, traffic management constraints, trip parameters, and/or the like that have been predetermined for a particular vehicle (e.g., a particular aerial vehicle). In certain embodiments, a flight path can be an emergency flight path for a vehicle.

In one or more embodiments, the term "emergency operations event" refers to a situation and/or circumstance that has the potential to impact the operation of an aerial vehicle. For instance, an emergency operations event can be an emergency situation impacting the operation of the aerial vehicle and/or one or more persons associated with the aerial vehicle. An emergency operations event can also be a circumstance affecting the optimization of one or more vehicle systems associated with the aerial vehicle. A few non-limiting examples of event types that can be associated with a respective emergency operations event include, a component failure event type, an emergency event type, a hazard event type, a mechanical failure event type, a logistical event type, an environmental event type, an optimization event type, a personnel health event type, and/or the like. Determination of an emergency operations event can be based in part on one or more portions of event data, telemetry data, and/or vehicle sensor data.

In one or more embodiments, the term "designated location" refers to a destination, a transportation hub, a logistics hub, and/or another type of geographical location that is configured to serve one or more inbound and/or outbound vehicles. Non-limiting examples of a designated location include an airport, a vertiport, a helipad, a hangar, a vehicle fueling station, a vehicle pool, a service station, a vehicle maintenance facility, a vehicle manufacturing facility, a vehicle sales facility, and/or the like.

In one or more embodiments, the term "aerial vehicle" refers to any manned or unmanned vehicle capable of air travel. Non-limiting examples of an aerial vehicle include an aircraft, an airplane, a helicopter, an unmanned aerial vehicle, an electric aerial vehicle, an electronic vertical takeoff or landing (eVTOL) aircraft, a jet, a drone, or a quadcopter. At least some aerial vehicles are controllable by system(s) onboard the aerial vehicle. At least some aerial vehicles are controllable by system(s) external from the aerial vehicle including, and without limitation, remote control system(s), ground system(s), and centralized control system(s). In various embodiments, an aerial vehicle can be an electric aerial vehicle that is powered partially or completely by a battery system integrated with the electric aerial vehicle.

In one or more embodiments, the term "computing device" refers to any computer, processor, circuitry, and/or other executor of computer instructions that is embodied in hardware, software, firmware, and/or any combination thereof. Non-limiting examples of a computing device include a computer, a processor, an application-specific integrated circuit, a field-programmable gate array, a personal computer, a smart phone, a laptop, a fixed terminal, a server, a networking device, and a virtual machine.

In one or more embodiments, the term "user computing device" refers to a computing device associated with a person, company, or other organizational structure that controls one or more systems. In some embodiments, a user computing device is associated with particular administrative credentials that define access to operation via a particular system.

In one or more embodiments, the term "control station system" refers to a computing system associated with a person, company, or other organizational structure that remotely controls and/or monitors one or more vehicles. In various embodiments, a control station system can be a command center for remotely operating and/or managing one or more vehicles. For example, a control station system can be a ground control station. In various embodiments, a control station system can provide vehicle control, telemetry and/or data communication links, data analysis and visualization, and/or one or more other functionalities with respect to one or more vehicles.

In one or more embodiments, the term "executable code" refers to a portion of computer program code stored in one or a plurality of locations that is executed and/or executable via one or more computing devices embodied in hardware, software, firmware, and/or any combination thereof. Executable code defines at least one particular operation to be executed by one or more computing devices. In some embodiments, a memory, storage, and/or other computing device includes and/or otherwise is structured to define any amount of executable code (e.g., a portion of executable code associated with a first operation and a portion of executable code associated with a second operation). Alternatively or additionally, in some embodiments, executable code is embodied by separate computing devices (e.g., a first datastore embodying first portion of executable code and a second datastore embodying a second portion executable code).

In one or more embodiments, the term "datastore," "database," and "data lake" refer to any type of non-transitory computer-readable storage medium. Non-limiting examples of a datastore, database, and/or data lake include hardware, software, firmware, and/or a combination thereof capable of storing, recording, updating, retrieving and/or deleting computer-readable data and information. In various embodiments, a datastore, database, and/or data lake in some embodiments is a cloud-based storage system accessible via a communications network by one or more components of the various embodiments of the present disclosure.

In one or more embodiments, the term "data value" refers to electronically managed data representing a particular value for a particular data attribute, operational parameter, sensor device, and/or the like.

The phrases "in an embodiment," "in one embodiment," "according to one embodiment," and the like generally mean that the particular feature, structure, or characteristic following the phrase in some embodiments is included in at least one embodiment of the present disclosure, and in some embodiments is included in more than one embodiment of the present disclosure (importantly, such phrases do not necessarily refer to the same embodiment). The word "exemplary" is used herein to mean "serving as an example, instance, or illustration." Any implementation described herein as "exemplary" is not necessarily to be construed as preferred or advantageous over other implementations. If the specification states a component or feature "can," "may," "could," "should," "would," "preferably," "possibly," "typically," "optionally," "for example," "often," or "might" (or other such language) be included or have a characteristic, that particular component or feature is not required to be included or to have the characteristic. Such component or feature in some embodiments is optionally included in some embodiments, or it in some embodiments is excluded.

As used herein, the terms "data," "content," "digital content," "data object," "information," and similar terms may be used interchangeably to refer to data capable of being transmitted, received, and/or stored in accordance with embodiments of the present invention. Thus, use of any such terms should not be taken to limit the spirit and scope of embodiments of the present invention. Further, where a computing device is described herein to receive data from another computing device, it will be appreciated that the data may be received directly from another computing device or may be received indirectly via one or more intermediary computing devices, such as, for example, one or more servers, relays, routers, network access points, base stations, hosts, and/or the like, sometimes referred to herein as a "network." Similarly, where a computing device is described herein to send data to another computing device, it will be appreciated that the data may be sent directly to another computing device or may be sent indirectly via one or more intermediary computing devices, such as, for example, one or more servers, relays, routers, network access points, base stations, hosts, and/or the like.

### EXAMPLE SYSTEMS, APPARATUSES, AND DATAFLOWS OF THE DISCLOSURE

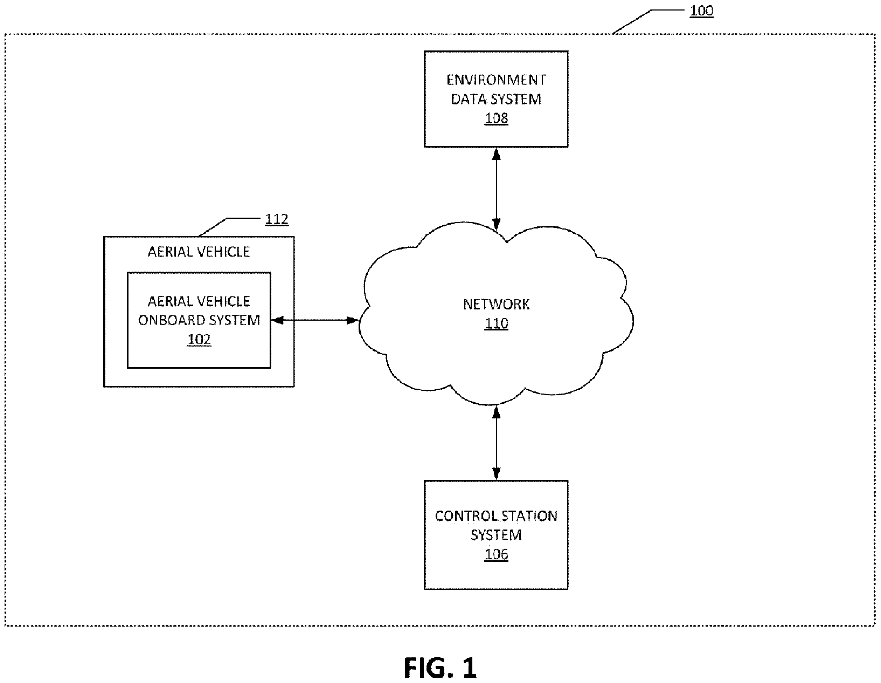

FIG. 1 illustrates an example system that provides 3D model augmentation for an aerial vehicle in accordance with at least some example embodiments of the present disclosure. Specifically, FIG. 1 depicts an example system 100 within which embodiments of the present disclosure may operate to visually augment a 3D model of an aerial vehicle 112 during operation of the aerial vehicle 112. As depicted, the system 100 includes aerial vehicle onboard system(s) 102 associated with the aerial vehicle 112. Additionally or alternatively, in some embodiments, the aerial vehicle 112 is communicable (e.g., via the aerial vehicle onboard system(s) 102) with one or more external computing device(s) and/or system(s). For example, in some embodiments, the aerial vehicle onboard system(s) 102 is optionally communicable with some or all of control station system(s) 106 and/or environment data system(s) 108. In some such embodiments, the aerial vehicle onboard system(s) 102 communicates with control station system(s) 106 and/or environment data system(s) 108 via one or more specially configured communications network(s), for example the network 110.

In some embodiments, the aerial vehicle onboard system(s) 102 includes any number of computing device(s) and/or system(s) embodied in hardware, software, firmware, and/or a combination thereof, that control, operate, and/or otherwise function onboard an aerial vehicle 112. For example, in some embodiments, the aerial vehicle onboard system(s) 102 includes one or more physical component(s) of the aerial vehicle 112, including and without limitation one or more display(s), flight management system(s), vehicle operation management system(s), engine(s), wing(s), prop(s), motor(s), antenna(s), landing gear(s), and/or the like. In some embodiments, the aerial vehicle onboard system(s) 102 includes one or more sensor(s) that gather, collect, and/or otherwise aggregates sensor data relevant to operation of the aerial vehicle 112, associated with the aerial vehicle 112, and/or otherwise associated with an environment of the aerial vehicle 112.

Additionally or alternatively, in some embodiments, the aerial vehicle onboard system(s) 102 includes one or more computing device(s) and/or system(s) embodied in hardware, software, firmware, and/or a combination thereof, that generates and/or otherwise causes rendering of one or more user interface(s) renderable to one or more display(s) onboard and/or otherwise associated with the aerial vehicle 112. In some embodiments such computing device(s) and/or system(s) specially configure some or all element(s) of user interface(s) to be rendered based at least in part on received data. It should be appreciated that the aerial vehicle onboard system(s) 102 in some embodiments includes any of a myriad of specially configured computing device(s) and/or system(s) that enable the aerial vehicle 112 to operate in a particular manner of airborne travel. For example, in various embodiments, the aerial vehicle onboard system(s) 102 may include a primary flight display (PFD), an electronic flight bag (EFB), a flight management system (FMS), a gateway computing device, and/or the like. In various embodiments, the aerial vehicle onboard system(s) 102 associated with a respective vehicle may be configured in a line replaceable unit (LRU).

In some embodiments, the aerial vehicle onboard system(s) 102 includes one or more personal computer(s), end-user terminal(s), monitor(s), or other display(s), and/or the like. Additionally or alternatively, in some embodiments, the aerial vehicle onboard system(s) 102 includes one or more data repository/data repositories embodied in hardware, software, firmware, and/or any combination thereof, to support functionality provided by the aerial vehicle onboard system(s) 102. For example, in some embodiments, such data repositories provide data storage functionality on the same computing device(s) and/or other dedicated computing device(s) of the aerial vehicle onboard system(s) 102. Additionally or alternatively still, in some embodiments, the aerial vehicle onboard system(s) 102 includes one or more specially configured integrated system(s), circuit(s), and/or the like that process data received by and/or control one or more other computing device(s) and/or system(s), or physical component(s), associated with the aerial vehicle 112.

The aerial vehicle 112 may embody any of a myriad of aerial vehicle types. The aerial vehicle 112 includes any number of physical component(s) that enable air travel, including and without limitation prop(s), rotor(s), engine(s), wing(s), and/or the like. Additionally or alternatively, the aerial vehicle 112 includes any number of a myriad of controls for operating the physical components of the aerial vehicle 112 to achieve such airborne travel. For example, in some embodiments, the aerial vehicle 112 includes a forward-flying aerial vehicle. In some embodiments, the aerial vehicle 112 includes a vertical takeoff and landing aerial vehicle. It will be appreciated that the aerial vehicle 112 may be entirely manually controlled, semi-autonomous, fully autonomous for one or more operations, or any combination thereof. Non-limiting examples of an aerial vehicle 112 include a plane generally, a helicopter, a drone, an eVTOL, a prop-based aircraft, a jet, and/or the like. Any particular vehicle type utilized in this disclosure is purely illustrative, and not to limit the scope and/or spirit of this disclosure or the appended claims presented herewith.

In some embodiments, the control station system(s) 106 includes one or more computing device(s) embodied in hardware, software, firmware, and/or the like that remotely controls and/or monitors the aerial vehicle 112. In some embodiments, the control station system(s) 106 includes one or more computing device(s) embodied in hardware, software, firmware, and/or the like that generate, assign, and/or maintain vehicle operation constraints (e.g., flight plan data, mission goals, etc.) for the aerial vehicle 112. For example, in some embodiments, the control station system(s) 106 include computing device(s) and/or system(s) of an air traffic control system and/or other authoritative entity that assigns flight plan information to the aerial vehicle 112. Such information includes, without limitation, flight plan information embodying a visual sight rules (VFR) flight plan, an instrument flight rules (IFR) flight plan, a composite flight plan, and/or the like defining conditions for operating an aerial vehicle 112 within a particular environment. In some embodiments, the control station system(s) 106 captures and/or otherwise obtains particular data for monitoring and/or controlling the aerial vehicle 112. In some embodiments, the control station system(s) 106 include computing device(s) and/or system(s) of an operation center (e.g., a remote operations platform) where a remote pilot can remotely control the aerial vehicle 112 and/or one or more other aerial vehicles. In some embodiments, the control station system(s) 106 includes one or more computing device(s) embodied in hardware, software, firmware, and/or the like that communicates with the aerial vehicle 112 to receive real-time telemetry data and/or manifest data (e.g., a manifest data structure) from the aerial vehicle 112. In some embodiments, the control station system(s) 106 includes one or more computing device(s) embodied in hardware, software, firmware, and/or the like that generates a visually augmented version of a 3D model for the aerial vehicle 112 based on the real-time telemetry data and/or the manifest data (e.g., a manifest data structure) received from the aerial vehicle 112.

In some embodiments, the control station system(s) 106 includes one or more application server(s), end user terminal(s), personal computer(s), mobile device(s), user device(s), and/or the like that generate, assign, and/or transmit flight plan information to aerial vehicle(s). Additionally or alternatively, in some embodiments, the control station system(s) 106 includes one or more data repository/repositories embodied in hardware, software, firmware, and/or a combination thereof, that stores 3D model information, flight plan information, links between flight plan information and particular aerial vehicle(s), and/or the like. In some such embodiments, the flight plan information includes navigational data, environmental data, weather data, and/or obstacle data for one or more environment(s) within which an aerial vehicle is or will be operating. Additionally or alternatively, in some embodiments, the control station system(s) 106 includes one or more computing device(s) and/or system(s) that detect and/or monitor operation of one or more aerial vehicle(s) within an environment. For example, in some embodiments, the control station system(s) 106 can include one or more radar system(s) that monitor one or more environment(s). In various embodiments, one or more portions of data associated with the control station system(s) 106 may be stored in a navigation database.

The environment data system(s) 108 includes one or more computing device(s) and/or system(s) that monitor, capture, and/or otherwise store data representing one or more aspect(s) of a real-world environment, object(s) therein, and/or aerial vehicle(s) therein. In some embodiments, the environment data system(s) 108 includes one or more data repository/repositories that store weather and/or obstacle data for one or more environment(s). Additionally or alternatively, in some embodiments, the environment data system(s) 108 includes one or more data repository/repositories that store data embodying other environmental aspect(s) that interact with or otherwise affect operation of aerial vehicle(s) in an environment, for example the aerial vehicle 112. In some embodiments, the environment data system(s) 108 includes a satellite system that monitors one or more aspect(s) of an environment, for example a satellite weather provider and/or satellite radio provider to the aerial vehicle 112. Alternatively or additionally still, in some embodiments, the environment data system(s) 108 embody or include a flight services data provider system. In some embodiments, the environment data system(s) 108 embodies a subsystem of the control station system(s) 106.

In some embodiments, the environment data system(s) 108 includes one or more application server(s), end user terminal(s), personal computer(s), mobile device(s), user device(s), and/or the like. Additionally or alternatively, in some embodiments, the environment data system(s) 108 includes one or more database server(s) specially configured to store data pushed from one or more other computing device(s) and/or system(s). In some embodiments, the environment data system(s) 108 includes one or more remote and/or cloud computing device(s) accessible to the aerial vehicle onboard system(s) 102 and/or control station system(s) 106 over a communications network, such as the network 110. In various embodiments, one or more portions of data associated with the environment data system(s) 108 may be stored in a navigation database.

In some embodiments the network 110 enables communication between various computing device(s) and/or system(s) utilizing one or more combination(s) of wireless and/or wired data transmission protocol(s). In this regard, the network 110 in some embodiments embodies any of a myriad of network configurations. In some embodiments, the network 110 embodies a public network (e.g., the Internet) in whole or in part. In some embodiments, the network 110 embodies a private network (e.g., an internal network between particular computing devices) in whole or in part. Alternatively or additionally, in some embodiments the network 110 embodies a direct or private connection facilitated over satellite or radio system(s) that enables long-range communication between aerial vehicle(s) and corresponding grounded system(s). In some other embodiments, the network 110 embodies a hybrid network (e.g., a network enabling internal communications between particular connected computing devices and external communications with other computing devices).

The network 110 in some embodiments includes one or more base station(s), relay(s), router(s), switch(es), cell tower(s), communications cable(s), satellite(s), radio antenna(s) and/or related control system(s), and/or associated routing station(s), and/or the like. In some embodiments, the network 110 includes one or more user entity-controlled computing device(s) and/or other enterprise device(s) (e.g., an end-user's or enterprise router, modem, switch, and/or other network access point) and/or one or more external utility devices (e.g., Internet service provider communication tower(s), cell tower(s), and/or other device(s)). In some embodiments, the aerial vehicle onboard system(s) 102 communicates with control station system(s) 106 and/or environment data system(s) 108 over the network 110 to receive and/or transmit the data described herein for generating the user interface(s) for providing to one or more display(s) of an aerial vehicle. In some embodiments, the network 110 embodies a communication channel (e.g., a Datalink communication channel) between the aerial vehicle 112 (e.g., via the aerial vehicle onboard system(s) 102) and the control station system 106 that communicatively couple the airborne system(s) to the ground system(s).

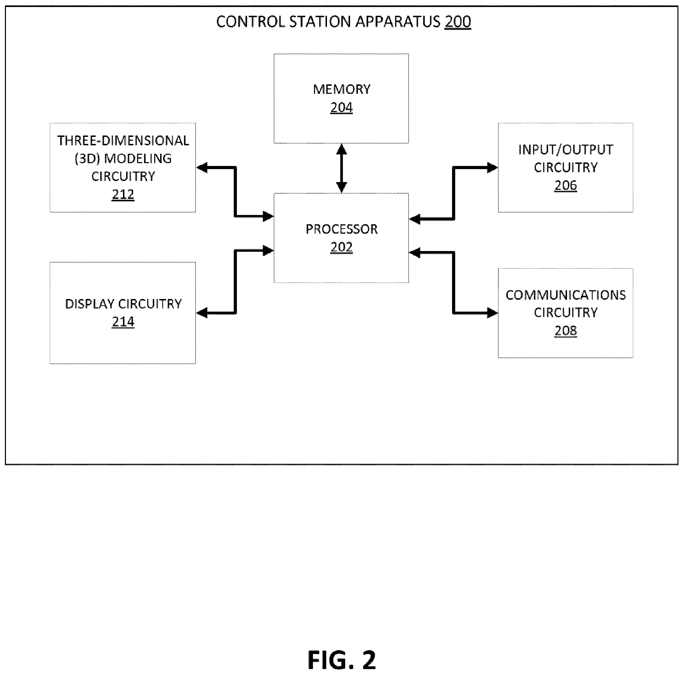

FIG. 2 illustrates an example apparatus in accordance with at least some example embodiments of the present disclosure. Specifically, FIG. 2 depicts a control station apparatus 200. In some embodiments, one or more computing device(s) and/or system(s) of the control station system 106 is embodied by one or more computing devices such as the control station apparatus 200 as depicted and described in FIG. 2.

As depicted, the control station apparatus 200 includes a processor 202, memory 204, input/output circuitry 206, communications circuitry 208, sensor(s) 210, 3D modeling circuitry 212, and/or display circuitry 214. In some embodiments, the control station apparatus 200 is configured, using one or more of the sets of circuitry embodying processor 202, memory 204, input/output circuitry 206, communications circuitry 208, 3D modeling circuitry 212, and/or display circuitry 214, to execute one or more operations described herein.

Although components are described with respect to functional limitations, it should be understood that the particular implementations necessarily include the use of particular computing hardware. It should also be understood that in some embodiments certain of the components described herein include similar or common hardware. For example, two sets of circuitry may both leverage use of the same processor(s), network interface(s), storage medium(s), and/or the like, to perform their associated functions, such that duplicate hardware is not required for each set of circuitry. The use of the term "circuitry" as used herein with respect to components of the apparatuses described herein should therefore be understood to include particular hardware configured to perform the functions associated with the particular circuitry as described herein.

Particularly, the term "circuitry" should be understood broadly to include hardware and, in some embodiments, software for configuring the hardware. For example, in some embodiments, "circuitry" includes processing circuitry, storage media, network interfaces, input/output devices, and/or the like. Alternatively or additionally, in some embodiments, other elements of the control station apparatus 200 provide or supplement the functionality of another particular set of circuitry. For example, the processor 202 in some embodiments provides processing functionality to any of the other sets of circuitry, the memory 204 provides storage functionality to any of other the sets of circuitry, the communications circuitry 208 provides network interface functionality to any of the other sets of circuitry, and/or the like.

In some embodiments, the processor 202 (and/or co-processor or any other processing circuitry assisting or otherwise associated with the processor) is/are in communication with the memory 204 via a bus for passing information among components of the control station apparatus 200. In some embodiments, for example, the memory 204 is non-transitory and includes for example, one or more volatile and/or non-volatile memories. In other words, for example, the memory 204 in some embodiments includes or embodies an electronic storage device (e.g., a computer readable storage medium). In some embodiments, the memory 204 is configured to store information, data, content, applications, instructions, or the like, for enabling the control station apparatus 200 to carry out various functions in accordance with example embodiments of the present disclosure. Furthermore, in various embodiments, the memory 204 is configured to store one or more portions of data related to a 3D model database, an emergency flight plan database, a performance database, a navigation database, and/or another type of database associated with a vehicle embodying a respective control station apparatus 200.

In various embodiments, the processor 202 is embodied in a number of different ways. For example, in some example embodiments, the processor 202 includes one or more processing devices configured to perform independently. Additionally or alternatively, in some embodiments, the processor 202 includes one or more processor(s) configured in tandem via a bus to enable independent execution of instructions, pipelining, and/or multithreading. The use of the terms "processor" and "processing circuitry" should be understood to include a single core processor, a multi-core processor, multiple processors internal to the control station apparatus 200, and/or one or more remote or "cloud" processor(s) external to the control station apparatus 200.

In an example embodiment, the processor 202 is configured to execute instructions stored in the memory 204 or otherwise accessible to the processor 202. Alternatively or additionally, the processor 202 in some embodiments is configured to execute hard-coded functionality. As such, whether configured by hardware or software methods, or by a combination thereof, the processor 202 represents an entity (e.g., physically embodied in circuitry) capable of performing operations according to an embodiment of the present disclosure while configured accordingly. Alternatively or additionally, as another example in some example embodiments, when the processor 202 is embodied as an executor of software instructions, the instructions specifically configure the processor 202 to perform the algorithms embodied in the specific operations described herein when such instructions are executed.

As one particular example embodiment, the processor 202 is configured to perform various operations associated with communicating with the aerial vehicle 112, receiving a manifest data structure from the aerial vehicle 112, receiving a 3D model and/or 3D model data from the aerial vehicle 112, receiving a 3D model and/or 3D model data from a 3D model database, receiving real-time telemetry data from the aerial vehicle 112, correlating real-time telemetry data for the aerial vehicle 112 with respective portions of the 3D model, generating a visually augmented version of the 3D for the aerial vehicle 112, causing a rendering of the visually augmented version of the 3D model via a display, displaying the visually augmented version of the 3D model, and/or dynamically modifying one or more visually augmented version of the 3D for the aerial vehicle 112 in real-time based on new telemetry data, for example as described with respect to managing and/or controlling the aerial vehicle 112 in FIG. 1 and/or as described further herein. In some embodiments, the processor 202 includes hardware, software, firmware, and/or a combination thereof, that additionally or alternatively generates and/or receives data including one or more portions of vehicle performance data, vehicle sensor data, environmental data, logistical data, emergency flight plan data, 3D protected zone data, and/or other data related to one or more situations impacting the operation of a vehicle (e.g., an aerial vehicle 112).

Additionally or alternatively, in some embodiments, the processor 202 includes hardware, software, firmware, and/or a combination thereof, that causes rendering the 3D model and/or information associated therewith via one or more electronic interfaces associated with the control station apparatus 200 and/or one or more electronic interfaces associated with other computing devices (e.g., a vehicle operations center apparatus associated with the vehicle operations center). Additionally or alternatively, in some embodiments, the processor 202 includes hardware, software, firmware, and/or a combination thereof, that, in real-time, updates a rendering of a user interface and/or interface element(s) thereof in response to updated data related to the real-time telemetry data, one or more adverse situations, and/or one or more portions of data associated with the operation of the aerial vehicle 112.

In some embodiments, the control station apparatus 200 includes input/output circuitry 206 that provides output to the user and, in some embodiments, to receive an indication of a user input (e.g., user input generated by an operator, crew member, and/or other human). In some embodiments, the input/output circuitry 206 is in communication with the processor 202 to provide such functionality. The input/output circuitry 206 in some embodiments comprises one or more user interface(s) and in some embodiments includes a display that comprises the interface(s) rendered as a web user interface, an application user interface, a user device, a backend system, or the like. In some embodiments, the input/output circuitry 206 also includes a keyboard, a mouse, a joystick, a touch screen, touch areas, soft keys a microphone, a speaker, or other input/output mechanisms. The processor 202, and/or input/output circuitry 206 comprising a processor, in some embodiments is configured to control one or more functions of one or more user interface elements through computer program instructions (e.g., software and/or firmware) stored on a memory accessible to the processor 202 (e.g., memory 204, and/or the like). In some embodiments, the input/output circuitry 206 includes or utilizes a user-facing application to provide input/output functionality to a computing device and/or other display associated with a user. In some embodiments, the input/output circuitry 206 includes a cockpit display, a navigation map display, a PFD, a head-up display (HUD), a vertical situation display (VSD), a Near-to-Eye display, an AR display, a VR display, and/or another type of display integrated as a part of a remote platform. Additionally or alternatively, in some embodiments, the input/output circuitry 206 includes one or more software-rendered user interface(s) including interface element(s) that depict particular data and/or information, and/or that receive user input.

The communications circuitry 208 includes any means such as a device or circuitry embodied in either hardware or a combination of hardware and software that is configured to receive and/or transmit data from/to a communications network and/or any other computing device, circuitry, or module in communication with the control station apparatus 200. In this regard, the communications circuitry 208 includes, for example in some embodiments, a network interface for enabling communications with a wired or wireless communications network. Additionally or alternatively in some embodiments, the communications circuitry 208 includes one or more network interface card(s), antenna(s), bus(es), switch(es), router(s), modem(s), and supporting hardware, firmware, and/or software, or any other device suitable for enabling communications via one or more communications network(s). Additionally or alternatively, the communications circuitry 208 includes circuitry for interacting with the antenna(s) and/or other hardware or software to cause transmission of signals via the antenna(s) or to handle receipt of signals received via the antenna(s). In some embodiments, the communications circuitry 208 enables transmission to and/or receipt of data from one or more computing device(s) and/or system(s) of control station system(s) 106 and/or environment data system(s) 108, in communication with the control station apparatus 200.

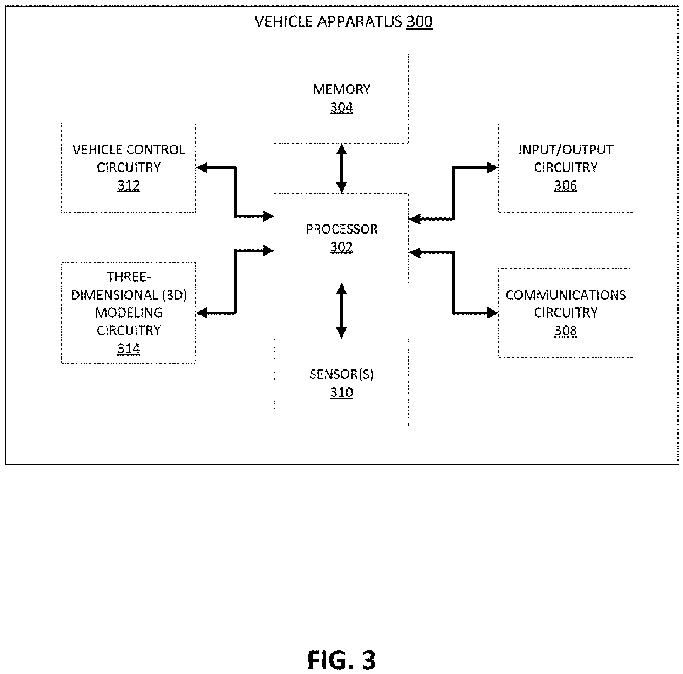

FIG. 3 illustrates an example vehicle apparatus in accordance with at least some example embodiments of the present disclosure. Specifically, FIG. 3 depicts a vehicle apparatus 300. In some embodiments, one or more computing device(s) and/or system(s) of a vehicle (e.g., an aerial vehicle 112), for example included in or embodied by the aerial vehicle onboard system(s) 102 onboard an aerial vehicle 112, is embodied by one or more computing devices such as the vehicle apparatus 300 as depicted and described in FIG. 3.

As depicted, the vehicle apparatus 300 includes a processor 302, memory 304, input/output circuitry 306, communications circuitry 308, sensor(s) 310, vehicle control circuitry 312, and/or 3D modeling circuitry 314. In some embodiments, the vehicle apparatus 300 is configured, using one or more of the sets of circuitry embodying processor 302, memory 304, input/output circuitry 306, communications circuitry 308, sensor(s) 310, vehicle control circuitry 312, and/or 3D modeling circuitry 314, to execute one or more operations described herein.

Although components are described with respect to functional limitations, it should be understood that the particular implementations necessarily include the use of particular computing hardware. It should also be understood that in some embodiments certain of the components described herein include similar or common hardware. For example, two sets of circuitry may both leverage use of the same processor(s), network interface(s), storage medium(s), and/or the like, to perform their associated functions, such that duplicate hardware is not required for each set of circuitry. In some embodiments, "circuitry" includes processing circuitry, storage media, network interfaces, input/output devices, and/or the like. Alternatively or additionally, in some embodiments, other elements of the vehicle apparatus 300 provide or supplement the functionality of another particular set of circuitry. For example, the processor 302 in some embodiments provides processing functionality to any of the other sets of circuitry, the memory 304 provides storage functionality to any of other the sets of circuitry, the communications circuitry 308 provides network interface functionality to any of the other sets of circuitry, and/or the like.

In some embodiments, the processor 302 (and/or co-processor or any other processing circuitry assisting or otherwise associated with the processor) is/are in communication with the memory 304 via a bus for passing information among components of the vehicle apparatus 300. In some embodiments, for example, the memory 304 is non-transitory and includes for example, one or more volatile and/or non-volatile memories. In other words, for example, the memory 304 in some embodiments includes or embodies an electronic storage device (e.g., a computer readable storage medium). In some embodiments, the memory 304 is configured to store information, data, content, applications, instructions, or the like, for enabling the vehicle apparatus 300 to carry out various functions in accordance with example embodiments of the present disclosure. Furthermore, in various embodiments, the memory 304 is configured to store one or more portions of data related to an emergency flight plan database, a performance database, a navigation database, and/or another type of database associated with a vehicle embodying a respective vehicle apparatus 300.

In various embodiments, the processor 302 is embodied in a number of different ways. For example, in some example embodiments, the processor 302 includes one or more processing devices configured to perform independently. Additionally or alternatively, in some embodiments, the processor 302 includes one or more processor(s) configured in tandem via a bus to enable independent execution of instructions, pipelining, and/or multithreading. The use of the terms "processor" and "processing circuitry" should be understood to include a single core processor, a multi-core processor, multiple processors internal to the vehicle apparatus 300, and/or one or more remote or "cloud" processor(s) external to the vehicle apparatus 300.

In an example embodiment, the processor 302 is configured to execute instructions stored in the memory 304 or otherwise accessible to the processor 302. Alternatively or additionally, the processor 302 in some embodiments is configured to execute hard-coded functionality. As such, whether configured by hardware or software methods, or by a combination thereof, the processor 302 represents an entity (e.g., physically embodied in circuitry) capable of performing operations according to an embodiment of the present disclosure while configured accordingly. Alternatively or additionally, as another example in some example embodiments, when the processor 302 is embodied as an executor of software instructions, the instructions specifically configure the processor 302 to perform the algorithms embodied in the specific operations described herein when such instructions are executed.

As one particular example embodiment, the processor 302 is configured to perform various operations associated with generating and/or transmitting real-time telemetry data related to the aerial vehicle 112, transmitting a manifest data structure related to the aerial vehicle 112, transmitting a 3D model related to the aerial vehicle 112, operating and/or reconfiguring the aerial vehicle onboard system(s) 102, establishing a communication session with the control station system 106, and/or one or more other operations as described further herein. In some embodiments, the processor 302 includes hardware, software, firmware, and/or a combination thereof, that generates and/or receives data including one or more portions of vehicle performance data, vehicle sensor data, environmental data, logistical data, and/or other data related to one or more adverse situations impacting the operation of a vehicle (e.g., an aerial vehicle 112).

Additionally or alternatively, in some embodiments, the processor 302 includes hardware, software, firmware, and/or a combination thereof, that causes rendering of a 3D model of the aerial vehicle 112 via one or more electronic interfaces associated with the vehicle apparatus 300 and/or one or more electronic interfaces associated with other computing devices (e.g., a vehicle operations center apparatus associated with the vehicle operations center). Additionally or alternatively, in some embodiments, the processor 302 includes hardware, software, firmware, and/or a combination thereof, that in real-time updates rendering of a user interface and/or interface element(s) thereof in response to updated data related to one or more adverse situations associated with the aerial vehicle 112, modifications to a setting for one or more components of the aerial vehicle 112, and/or one or more portions of data associated with the operation of the aerial vehicle 112. Additionally or alternatively, in some embodiments, the processor 302 includes hardware, software, firmware, and/or a combination thereof, that modifies one or more settings related to the aerial vehicle onboard system 102 and/or one or more components of the aerial vehicle 112.

In some embodiments, the vehicle apparatus 300 includes input/output circuitry 306 that provides output to the user and, in some embodiments, to receive an indication of a user input (e.g., user input generated by a pilot, operator, crew member, and/or passenger). In some embodiments, the input/output circuitry 306 is in communication with the processor 302 to provide such functionality. The input/output circuitry 306 in some embodiments comprises one or more user interface(s) and in some embodiments includes a display that comprises the interface(s) rendered as a web user interface, an application user interface, a user device, a backend system, or the like. In some embodiments, the input/output circuitry 306 also includes a keyboard, a mouse, a joystick, a touch screen, touch areas, soft keys a microphone, a speaker, or other input/output mechanisms. The processor 302, and/or input/output circuitry 306 comprising a processor, in some embodiments is configured to control one or more functions of one or more user interface elements through computer program instructions (e.g., software and/or firmware) stored on a memory accessible to the processor 302 (e.g., memory 304, and/or the like). In some embodiments, the input/output circuitry 306 includes or utilizes a user-facing application to provide input/output functionality to a computing device and/or other display associated with a user. In some embodiments, the input/output circuitry 306 includes a cockpit display, a navigation map display, a PFD, an HUD, a VSD, a Near-to-Eye display, an AR display, a VR display, and/or another type of display onboard an aerial vehicle or integrated as a part of a remote platform. Additionally or alternatively, in some embodiments, the input/output circuitry 306 includes one or more software-rendered user interface(s) including interface element(s) that depict particular data and/or information, and/or that receive user input.

The communications circuitry 308 includes any means such as a device or circuitry embodied in either hardware or a combination of hardware and software that is configured to receive and/or transmit data from/to a communications network and/or any other computing device, circuitry, or module in communication with the vehicle apparatus 300. In this regard, the communications circuitry 308 includes, for example in some embodiments, a network interface for enabling communications with a wired or wireless communications network. Additionally or alternatively in some embodiments, the communications circuitry 308 includes one or more network interface card(s), antenna(s), bus(es), switch(es), router(s), modem(s), and supporting hardware, firmware, and/or software, or any other device suitable for enabling communications via one or more communications network(s). Additionally or alternatively, the communications circuitry 308 includes circuitry for interacting with the antenna(s) and/or other hardware or software to cause transmission of signals via the antenna(s) or to handle receipt of signals received via the antenna(s). In some embodiments, the communications circuitry 308 enables transmission to and/or receipt of data from one or more computing device(s) and/or system(s) of control station system(s) 106 and/or environment data system(s) 108, in communication with the vehicle apparatus 300. In some embodiments, the communications circuitry 308 includes circuitry for transmitting a manifest data structure, a 3D model, and/or real-time telemetry data to control station system(s) 106.

The sensor(s) 310 includes hardware, software, firmware, and/or a combination thereof, that supports generation, capturing, aggregating, retrieval, and/or receiving of one or more portions of sensor data related to the aerial vehicle 112. In some embodiments, the sensor(s) 310 includes hardware, software, firmware, and/or a combination thereof, that supports generation, capturing, aggregating, retrieval, and/or receiving of one or more portions of telemetry data related to the aerial vehicle 112. In some embodiments, the sensor(s) 310 includes one or more discrete component(s) of a vehicle (e.g., an aerial vehicle 112). The sensor(s) 310 in some embodiments are affixed to, within, and/or otherwise as a part of an aerial vehicle including or otherwise associated with the vehicle apparatus 300. For example, in some embodiments, one or more of the sensor(s) 310 is/are mounted to the aerial vehicle, such as the aerial vehicle 112. Non-limiting examples of sensor(s) 310 include altimeter(s) (e.g., radio and/or barometric), pressure sensor(s), pilot tube(s), anemometer(s), image camera(s), video camera(s), infrared sensor(s), speed sensor(s), battery sensor(s), fuel level sensor(s), biological sensor(s) and/or the like. In some embodiments, the sensor(s) 310 are integrated with, or embodied by, one or more of the aerial vehicle onboard system(s) 102 such that the sensor(s) 310 generate, collect, monitors, and/or otherwise obtain data related to the one or more aerial vehicle onboard system(s) 102.

In some embodiments, the sensor(s) 310 additionally or alternatively include any of a myriad of sensor(s) conventionally associated with drone(s), helicopter(s), and/or other urban air mobility aerial vehicle(s). Additionally or alternatively, in some embodiments, the sensor(s) 310 include one or more high-sensitivity sensor(s) to facilitate enable high accuracy capturing of data in certain circumstances. For example, in some embodiments, the sensor(s) 310 includes one or more high-sensitivity sensor(s) that capture detailed data while an aerial vehicle is in flight. Such higher fidelity sensor(s) in some embodiments supplement and/or, in other embodiments, replace the data captured by such sensor(s) with lower fidelity.

In some embodiments, the sensor(s) 310 includes hardware, software, firmware, and/or a combination thereof, embodying one or more navigation sensor(s). In some embodiments, the navigation sensor(s) includes a global positioning satellite (GPS) tracking chip and/or the like enabling location services to be requested and/or determined for a particular aerial vehicle. Additionally or alternatively, in some embodiments, the sensor(s) 310 includes hardware, software, firmware, and/or any combination thereof, embodying inertial navigation sensor(s) that measures speed, acceleration, orientation, and/or position-related data in a 3D environment. Additionally or alternatively, in some embodiments, the sensor(s) 310 includes one or more camera(s) associated with a synthetic vision system (SVS). In some such embodiments, such an SVS camera captures image data representation(s) of the real-world environment around an aerial vehicle for use in generating corresponding user interface(s) depicting he captured image data, augmenting such image data, and/or otherwise providing data to enable an operator to acquire situational awareness based at least in part on the captured image data. It will be appreciated that, in some embodiments, the sensor(s) 310 includes a separate processor, specially configured field programmable gate array (FPGA), or a specially programmed application specific integrated circuit (ASIC).

The vehicle control circuitry 312 includes hardware, software, firmware, and/or a combination thereof, that supports functionality associated with navigating and/or controlling a vehicle (e.g., an aerial vehicle 112). In some embodiments, vehicle control circuitry 312 can control and/or configure one or more of the aerial onboard system(s) 102. In some embodiments, vehicle control circuitry 312 includes hardware, software, firmware, and/or a combination thereof, that receives flight plan data (e.g., embodying a flight plan), location service(s) data representing a location of an aerial vehicle 112, and/or the like. Additionally or alternatively, in some embodiments, the vehicle control circuitry 312 includes hardware, software, firmware, and/or a combination thereof, that depicts interface element(s) representing at least a flight path or indication where the aerial vehicle 112 is currently traveling and/or should travel.

Additionally or alternatively, in some embodiments, the vehicle control circuitry 312 includes hardware, software, firmware, and/or a combination thereof, that autonomously control(s) one or more component(s) of an aerial vehicle. In some such embodiments, the vehicle control circuitry 312 autonomously control(s) one or more physical component(s) of a vehicle (e.g., an aerial vehicle 112) to facilitate movement of the vehicle along a particular path and/or to rectify operation of the one or more physical component(s) to satisfy performance criteria for the one or more physical component(s). Alternatively or additionally, in some embodiments, the vehicle control circuitry 312 includes hardware, software, firmware, and/or a combination thereof, that semi-autonomously control(s) one or more component(s) of an aerial vehicle, for example where certain aspects of the operation of the aerial vehicle are autonomously performed and others (e.g., directional control) is/are controlled by a user (e.g., a pilot). Alternatively or additionally, in some embodiments, the vehicle control circuitry 312 includes hardware, software, firmware, and/or a combination thereof, that receives pilot input for controlling one or more component(s) of an aerial vehicle, for example via vehicle flight control(s) to alter speed and/or direction of the aerial vehicle. Alternatively or additionally, in some embodiments, the vehicle control circuitry 312 includes hardware, software, firmware, and/or a combination thereof, that causes changes to an operational mode (e.g., an economy mode) of an aerial vehicle, for example autonomously based at least in part on one or more data-driven adverse situation(s) and/or triggers, or in response to user input initiating the change in operational mode. In some embodiments, the vehicle control circuitry 312 includes hardware, software, firmware, and/or a combination thereof, that controls one or more component(s) of an aerial vehicle based on a flight path associated with a flight plan for the aerial vehicle 112. It will be appreciated that, in some embodiments, the vehicle control circuitry 312 includes a separate processor, specially configured field programmable gate array (FPGA), or a specially programmed application specific integrated circuit (ASIC).

The 3D modeling circuitry 314 includes hardware, software, firmware, and/or a combination thereof, that supports functionality associated with generating, broadcasting, and/or otherwise managing a 3D model for a vehicle (e.g., an aerial vehicle 112). For example, the 3D modeling circuitry 314 can execute, at least in part, one or more portions of program code for encoding and/or transmitting 3D model data for a 3D model related to the aerial vehicle 112. In various embodiments, the 3D modeling circuitry 314 includes hardware, software, firmware, and/or a combination thereof, that supports functionality associated with generating, broadcasting, and/or otherwise managing manifest data (e.g., a manifest data structure) for a vehicle (e.g., an aerial vehicle 112). For example, the manifest data (e.g., manifest data structure) can include a parameterized format for respective sub-components of the aerial vehicle 112 that links telemetry parameters to respective portions of the 3D model for the aerial vehicle 112.

In various embodiments, the 3D modeling circuitry 314 configures the 3D model for rendering via a display of the aerial vehicle 112 and/or the control station system 106. For example, the 3D modeling circuitry 314 can configure the 3D model for rendering via a display associated with the aerial vehicle onboard system 102 and/or the control station system 106. In various embodiments, the 3D modeling circuitry 314 causes rendering of a graphical element associated with the 3D model via a display of the aerial vehicle 112 and/or a display of the control station system 106.

In various embodiments, the 3D modeling circuitry 314 determines a mode of communication for the broadcasting the real-time telemetry data, the manifest data (e.g., the manifest data structure), and/or the 3D model data. The mode of communication can be wireless communication, satellite communication, LEO satellite communication, or another mode of communication. In some embodiments, in response to the aerial vehicle 112 establishing a communication connection with the control station system 106, the 3D modeling circuitry 314 can broadcast the manifest data (e.g., the manifest data structure), and/or the 3D model data to the control station system 106. In various embodiments, the 3D modeling circuitry 314 can determine a 3D model data format for the 3D model data based on the mode of communication and/or conditions for the communication connection. For example, the 3D modeling circuitry 314 can determine whether to broadcast a low fidelity version of the 3D model data, a medium fidelity version of the 3D model data, or a high fidelity version of the 3D model data based on the mode of communication and/or conditions for the communication connection.

It will be appreciated that, further in some embodiments, two or more of the sets of circuitries 302-314 are combinable. Alternatively or additionally, in some embodiments, one or more of the sets of circuitry 302-314 perform some or all of the functionality described associated with another component. For example, in some embodiments, one or more of the sets of circuitry 302-314 are combined into a single component embodied in hardware, software, firmware, and/or a combination thereof. For example, in some embodiments, two or more of the vehicle control circuitry 312 and 3D modeling circuitry 314 are embodied by a single set of circuitry that performs the combined operations of the individual sets of circuitry. Similarly, in some embodiments, one or more of the sets of circuitry, for example vehicle control circuitry 312 and/or 3D modeling circuitry 314 is/are combined with the processor 302, such that the processor 202 performs one or more of the operations described above with respect to each of these other sets of circuitry.

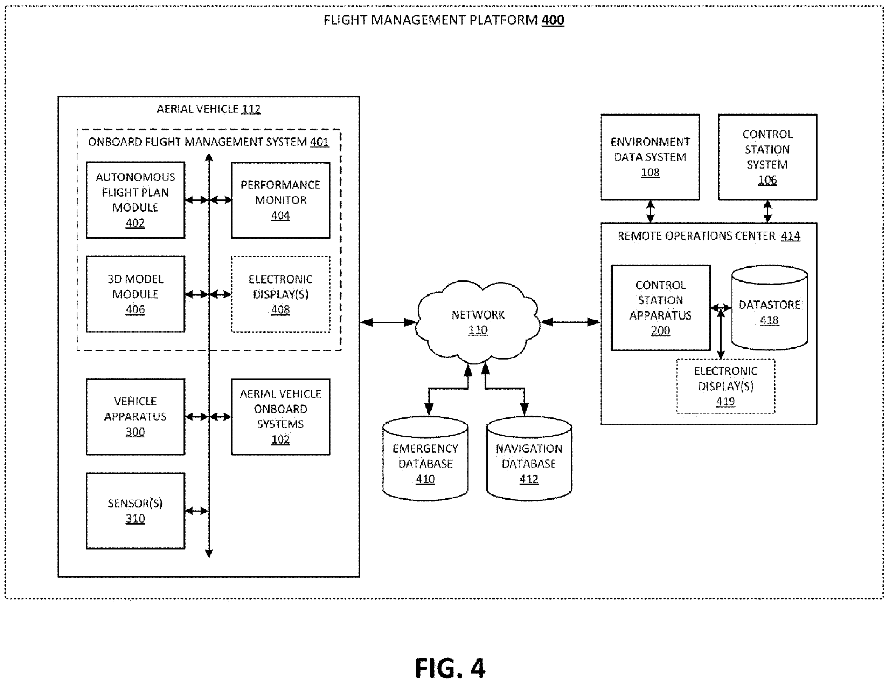

FIG. 4 illustrates an example flight management platform 400 in accordance with at least some example embodiments of the present disclosure. As depicted, FIG. 4 depicts various operational services, systems, components, apparatuses, and datastores embodied by the flight management platform 400. For example, the flight management platform 400 includes remote operations center 414 comprising the control station apparatus 200 and/or a datastore 418. In various embodiments, the remote operations center 414 integrates and/or communicates with the one or more environment data system(s) 108 and/or one or more control station system(s) 106. For example, in some embodiments, the control station system(s) 106 includes the control station apparatus 200. In various embodiments, the remote operations center 414, environment data system(s) 108, and/or the control station system(s) 106 in some embodiments communicate via the network 110.

The flight management platform 400 also comprises an onboard flight management system 401 embodied by the aerial vehicle 112. In various embodiments, the onboard flight management system 401 in some embodiments is integrates with, or is embodied by, the vehicle apparatus 300. Additionally or alternatively, in various embodiments, the onboard flight management system 401 integrates with the aerial vehicle onboard system 102 and/or the sensors 310 associated with the aerial vehicle 112. In various embodiments, the remote operations center 414 communicates with the onboard flight management system 401 via the network 110. For example, the remote operations center 414 communicates with the onboard flight management system 401 through one or more of the component parts of the control station apparatus 200 (e.g., communications circuitry) and one or more component parts of the vehicle apparatus 300 (e.g., communications circuitry 308) via the network 110. The onboard flight management system 401 of a respective vehicle (e.g., the aerial vehicle 112) comprises an autonomous flight plan module 402, a performance monitor 404, a 3D model module 406, and/or one or more electronic displays 408.

As will be further detailed herein, due to the distributed nature of the various embodiments of the present disclosure, the flight management platform 400 and the operational systems and/or services comprised therein in some embodiments is configured to freely pass data via one or more communications networks (e.g., network 110) in order to optimally delegate one or more operations described herein to one or more respective computing devices associated with the flight management platform 400. This delegation of operations provides the benefit of optimizing the capabilities of a particular vehicle (e.g., a particular aerial vehicle 112) based at least in part on the processing power associated with the particular vehicle. As will be appreciated, the delegation of certain methods, procedures, calculations, computations, configurations, predictions, and/or the like throughout the distributed operational systems and/or services of the flight management platform 400 reduces the load on the aerial vehicle onboard system(s) 102 of the vehicle as well as the load on the computing devices (e.g., the control station apparatus 200) of the remote operations center 414.

The flight management platform 400 comprises many data storage systems deployed in various configurations. As defined herein, database (e.g., emergency database 410 and navigation database 412) and/or datastore (e.g., datastore 418) in some embodiments is any type of non-transitory computer-readable storage medium. Non-limiting examples include hardware, software, firmware, and/or a combination thereof capable of storing, recording, updating, retrieving and/or deleting computer-readable data and information related to the flight management platform 400. In various embodiments, a database (e.g., emergency database 410 and navigation database 412) and/or datastore (e.g., datastore 418) in some embodiments is a cloud-based storage system accessible via a communications network (e.g., the network 110) by one or more components of the various embodiments of the present disclosure.

The control station apparatus 200 in some embodiments is a computing apparatus configured to generate one or more interactive user interfaces for rendering on one or more electronic displays associated with the remote operations center 414. For example, in some embodiments, the control station apparatus 200 is configured to generate an interactive user dashboard comprising various interactive interface elements representing data related to the flight management platform 400, data related to one or more onboard flight management system(s) 301, data related to one or more vehicles (e.g., one or more aerial vehicle(s) 112), data related to the one or more system(s) integrated with the remote operations center 414, and/or data related to the one or more storage system(s) associated with the flight management platform 400. In some embodiments, the control station apparatus 200 is configured to generate an interactive user dashboard comprising a visually augmented version of the 3D model for the aerial vehicle 112. As such, the control station apparatus 200, via the one or more interactive user interfaces, is configured to remotely monitor and/or control the aerial vehicle 112 based at least in part on the visually augmented version of the 3D model for the aerial vehicle 112.

In some embodiments, the control station apparatus 200, via the one or more interactive user interfaces, is configured to initialize, configure, update, modify, and/or otherwise set up an onboard flight management system 401 associated with a particular vehicle (e.g., aerial vehicle 112). Additionally or alternatively, the control station apparatus 200, via the one or more interactive user interfaces, is configured to initialize, configure, update, modify, and/or otherwise set up one or more components associated with a particular onboard flight management system 401 such as, for example, the autonomous flight plan module 402, the performance monitor 404, the 3D model module 406, and/or the electronic displays 408.

The datastore 418 associated with the remote operations center 414 in some embodiments is configured to store, retrieve, configure, modify, and/or otherwise manage one or more portions of data related to the flight management platform 400. For instance, the datastore 418, in some embodiments, stores 3D model data, telemetry data, manifest data (e.g., one or more manifest data structures), vehicle performance data, adverse situation mitigation data, and/or one or more portions of training data for training and/or re-training the various models associated with the onboard flight management system 401 (e.g., the vehicle performance prediction model). Additionally, the datastore 418 in some embodiments stores one or more portions of data associated with the environment data system(s) 108 and/or the control station system(s) 106.

Furthermore, the datastore 418 is configured to store one or more portions of data related to one or more vehicles associated with a vehicle fleet related to the flight management platform 400. For example, the datastore 418 in some embodiments stores one or more vehicle identifiers, vehicle load identifiers, vehicle component identifiers, onboard flight management system identifiers, vehicle fleet data, vehicle mission data, and/or any other data pertinent to the one or more vehicles in a vehicle fleet associated with the flight management platform 400. Additionally, the datastore 418 can store one or more portions of personnel data related to one or more vehicle operators, vehicle pilots, vehicle crew members, ground crew members, management personnel, and/or passengers associated with the flight management platform 400.

The onboard flight management system 401, in some embodiments, integrates with, or can be embodied by, a computing device such as a line replaceable unit (LRU). For example, the onboard flight management system 401 in some embodiments is embodied by an aerospace gateway LRU configured to communicate with one or more vehicle system(s). The remote operations center 414 and one or more onboard flight management system(s) 301 associated with one or more respective vehicles remain in constant communication and are configured to transmit and/or receive data related to the operation of the one or more vehicles via a communications network (e.g., network 110). In this regard, the onboard flight management system 401 in some embodiments generates and transmits one or more requests to the remote operations center 414 via the communications network. The one or more requests include, but are not limited to, a request for one or more portions of data including, but not limited to, environmental data, vehicle operation management data, vehicle data, logistics data, hazard data, air traffic data, road traffic data, and/or the like.

Additionally, the onboard flight management system 401 is configured to log and/or transmit one or more portions of data related to the vehicle to the remote operations center 414. For example, the onboard flight management system 401 is configured to transmit one or more portions of telemetry data related to the aerial vehicle 112. Additionally or alternatively, the onboard flight management system 401 is configured to transmit one or more portions of vehicle performance data related to the real-time performance (e.g., the performance of a battery system) of the aerial vehicle 112. Additionally or alternatively, the onboard flight management system 401 is configured to transmit one or more portions of data related to a predicted energy expenditure of the vehicle based at least in part on a trip plan associated with the aerial vehicle 112.

In various embodiments, the onboard flight management system 401 is configured to execute an emergency flight plan process by calculating an impact of one or more flight plan parameters on the one or more vehicle systems associated with a respective vehicle (e.g., the aerial vehicle 112), where the one or more trip parameters comprise at least one of a vehicle type, a vehicle battery system, a number of passengers, a vehicle payload weight, and/or one or more environmental factors. Additionally, the onboard flight management system 401 can receive one or more flight plans associated with a respective vehicle. The onboard flight management system 401 is configured to determine, based on inputting results from the vehicle performance validation process and a particular flight plan into the 3D model module 406, whether the particular flight plan is feasible. In various embodiments, determining whether the particular flight plan is feasible comprises correlating the particular flight plan and/or the results from the vehicle performance validation process with one or more current values associated with one or more aerial vehicle parameters associated with the aerial vehicle 112.

The performance monitor 404 is an ML model that is specially configured to receive one or more portions of telemetry data (e.g., data related to one or more battery parameters) and, based at least in part on the one or more portions of telemetry data, generate one or more portions of vehicle performance data describing one or more operational states of the vehicle. Additionally, the performance monitor 404 associated with an onboard flight management system 401 is configured to identify, classify, categorize, and/or analyze one or more adverse situations impacting the operation of a vehicle.

The performance monitor 404 determines whether the vehicle is in a nominal state (e.g., a nominal operational state) or an adverse state (e.g., an adverse operational state). The performance monitor 404 in some embodiments generates one or more portions of model output (e.g., vehicle performance data) configured to describe the current status, energy expenditure, operational parameters, data values, operational modes, and/or configurations of one or more vehicle systems associated with the vehicle. In this regard, if the performance monitor 404 determines that one or more adverse situations are taking place that are impacting the operation of the vehicle, the performance monitor 404 determines how the one or more adverse situations are related to (e.g., how the one or more adverse situations are impacting) the respective sub-components of a vehicle systems (e.g., a battery system, a control system, and/or another system of the vehicle).

As such, the performance monitor 404 generates one or more portions of vehicle performance data related to the current operational status of the vehicle as model output. The one or more portions of vehicle performance data are one or more portions of data that have been configured for logging, analysis, ML model input, ML model training, and/or storage. For example, one or more portions of vehicle performance data in some embodiments captures the nominal state (e.g., nominal state) of the vehicle by logging, storing, and/or otherwise saving a current configuration of the one or more vehicle systems as well as how the configuration of the one or more vehicle systems relates to the current nominal operation of the vehicle. Similarly, the performance monitor 404 in some embodiments generates one or more portions of vehicle performance data capturing an adverse state (e.g., an adverse operational state) related to one or more adverse situations impacting the operation of the vehicle and the respective vehicle systems associated with the vehicle.

Vehicle performance data associated with a nominal state of a particular vehicle in some embodiments is used in one or more data recovery operations for reverting the particular vehicle from an adverse state back into a nominal state. For example, the vehicle performance data associated with the nominal state in some embodiments comprises one or more operational parameters, data values, operational modes, and/or configurations of one or more vehicle systems. As such, the vehicle performance data associated with the nominal state in some embodiments is utilized to reconfigure, re-initialize, and/or otherwise update the one or more vehicle systems such that the vehicle resumes operating in a manner congruent with the corresponding nominal state. In various embodiments, one or more portions of data related to the current operational state of the vehicle, one or more portions of vehicle performance data, and/or any data generated and/or managed by the performance monitor 404 in some embodiments is rendered via one or more computing device(s) associated with the remote operations center 414.

Furthermore, in various embodiments, the performance monitor 404 in some embodiments is configured to classify the criticality of one or more adverse situations associated with a vehicle (e.g., an aerial vehicle 112). For instance, once the performance monitor 404 determines that one or more adverse situations that can impact the operation of the vehicle is occurring, the performance monitor 404 determines an adverse situation severity level associated with the one or more adverse situations. As a non-limiting example, the performance monitor 404 in some embodiments classifies one or more adverse situations as having a low severity level, a moderate severity level, a high severity level, a critical severity level, and/or the like. In various embodiments, one or more adverse situation severity thresholds in some embodiments are predetermined and incorporated by the vehicle performance prediction model such that when a respective adverse situation severity level associated with the one or more adverse situations satisfies the one or more adverse situation severity thresholds, the vehicle performance prediction model generates one or more recommendations to address the one or more adverse situations.

The performance monitor 404 in some embodiments determines a respective adverse situation type associated with one or more adverse situations impacting the operation of the vehicle. One or more adverse situation types in some embodiments are determined based in part on one or more portions of vehicle performance data indicative of a nominal scenario, an emergency scenario, a hazard scenario, a scenario that alters the voyage of the aerial vehicle, and/or a change in the operation of a system affecting control of the aerial vehicle. In various embodiments, at least a portion of the vehicle performance data is based at least in part on vehicle sensor data collected, measured, calculated, and/or otherwise generated by one or more sensors (e.g., one or more sensors 210) associated with the vehicle.

A few non-limiting examples of adverse situation types that in some embodiments is associated with a respective adverse situation include, an emergency adverse situation type, a hazard adverse situation type, a mechanical failure adverse situation type, a logistical adverse situation type, an environmental adverse situation type, an optimization adverse situation type, a personnel health adverse situation type, and/or the like associated with one or more sub-components of the aerial vehicle 112. In some embodiments, adverse situation types in some embodiments are associated with a predefined adverse situation severity level. For example, in some embodiments, a logistical adverse situation type in some embodiments is automatically associated with a low severity level. However, the performance monitor 404 in some embodiments determines that a particular adverse situation associated with a logistical adverse situation type has a high adverse situation severity level due to various respective circumstances.

In some embodiments, the performance monitor 404 is configured to provide telemetry data related to the current state of a vehicle (e.g., the aerial vehicle 112) via, for example, the vehicle apparatus 300 and/or the control station apparatus 200. For example, the performance monitor 404 can be configured to provide telemetry data related to a nominal state of the vehicle, an adverse state of the vehicle, the one or more adverse situations impacting the operation of the vehicle, the vehicle performance data associated with the vehicle, the vehicle sensor data associated with the vehicle, and/or the like.

The performance monitor 404 is also configured to transmit data related to one or more portions of vehicle performance data, data related to one or more adverse situations, and/or data related to one or more operational states to the control station system 106 to facilitate the mitigation of one or more adverse situations impacting the aerial vehicle 112 via the visually augmented version of the 3D model for the aerial vehicle 112.

The 3D model module 406 comprises hardware, software, firmware, and/or a combination thereof associated with an onboard flight management system 401 that is configured to manage a 3D model for the aerial vehicle 112.

The electronic displays 408 associated with the onboard flight management system 401 may comprise, in various embodiments, one or more cockpit displays, one or more VSDs, one or more PFDs, one or more displays associated with an FMS, one or more displays associated with a navigation system, one or more displays associated with one or more respective LRUs, one or more computer displays, and/or the like.

The emergency database 410 is configured to store and/or manage one or more portions of data related to emergency flight plan data, telemetry data, vehicle performance data, vehicle sensor data, adverse situation data, nominal state data, adverse state data, and/or the like associated with one or more current or previously executed trip plans associated with one or more respective vehicles (e.g., aerial vehicle 112) associated with the flight management platform 400. In various embodiments, the emergency database 410 can receive one or more portions of data from a particular vehicle (e.g., an aerial vehicle 112) via the network 110. Furthermore, the one or more portions of aforementioned data can be associated with a vehicle identifier of a respective vehicle (e.g., an aerial vehicle 112). As such, the one or more portions of data comprised in the emergency database 410 can be used to generate a visually augmented version of the 3D model for the aerial vehicle 112.

The navigation database 412 is configured to store and/or manage one or more portions of data related to one or more travel hubs, one or more travel routes, one or more waypoints, one or more destinations, one or more locations, one or more environmental features, one or more obstacles, and/or one or more portions of logistical information that may impact, aid, facilitate, enhance, and/or otherwise pertain to one or more trip plans associated with one or more respective vehicles associated with the flight management platform 400. Furthermore, the navigation database 412, in various embodiments, is configured to store and/or manage one or more portions of data associated with the environment data system 108 and/or the control station system 106.

In various embodiments, the emergency database 410 and/or the navigation database 412 can be configured as cloud-based storage systems. As such, the one or more portions of data comprised in the emergency database 410 and/or the navigation database 412 can be accessed, retrieved, updated, and/or managed by the vehicle apparatus 300 via the network 110. Additionally or alternatively, in various embodiments, the one or more portions of data comprised in the emergency database 410 and/or the navigation database 412 can be accessed, retrieved, updated, and/or managed by the control station apparatus 200 via the network 110. Additionally or alternatively, the one or more portions of data comprised in the emergency database 410 and/or the navigation database 412 can, in various embodiments, be stored locally in the vehicle apparatus 300 and/or the control station apparatus 200.

As described herein, in various embodiments, the flight management platform 400 comprises the remote operations center 414. In some embodiments, the remote operations center 414 can be configured for the offboard management and control of a fleet of vehicles associated with an enterprise. In this regard, the flight management platform 400 is configured as a distributed management system such that one or more vehicles integrate with a respective onboard flight management system 401 communicably coupled to the remote operations center 414. The remote operations center 414, in conjunction with a particular instance of the onboard flight management system 401 associated with a particular vehicle (e.g., the aerial vehicle 112), is configured to monitor, manage, and/or improve the performance of the particular vehicle by providing data to one or more operators associated with the particular vehicle. The remote operations center 414 and one or more onboard flight management system(s) 401 associated with one or more respective vehicles remain in constant contact and are configured to transmit and/or receive data related to the operation of the one or more vehicles via the network 110. The remote operations center 414 comprises one or more computing device(s) (e.g., the control station apparatus 200), one or more machine learning (MI,) model(s), and/or one or more datastore(s) (e.g., the datastore 418) configured to monitor and/or manage one or more vehicles. In various embodiments, the remote operations center 414 additionally includes one or more electronic displays 419. The one or more electronic displays 419 can be associated with one or more computing devices of the remote operations center 414. For example, the one or more electronic displays 419 can respectively be a display of the control station system 106. In various embodiments, the one or more electronic displays 419 can respectively be a display of a computer, a smart phone, a laptop, a tablet, a virtual reality device, an augmented reality device, or another type of computing device.

In various embodiments, the onboard flight management system 401 associated with a respective vehicle (e.g., an electric aerial vehicle) can transmit one or more portions of data to the remote operations center 414 via the network 110. For example, the onboard flight management system 401 can be configured to transmit one or more portions of data related to telemetry data, a current energy expenditure of the vehicle, one or more current values associated with one or more respective battery parameters associated with a battery system of the vehicle, data related to an adverse situation, and/or the like. In this regard, in various embodiments, the control station apparatus 200 of the remote operations center 414 can be configured to execute one or more operations associated with the onboard flight management system 401. For example, in various embodiments such as, for example, when an electric aerial vehicle is completely autonomous, the control station apparatus 200 can be configured to perform at least a portion of the processing associated with the onboard flight management system 401 associated with the electric aerial vehicle. As such, the computational resources needed by the electronic aerial vehicle may be advantageously reduced.

### OPERATIONAL EXAMPLES OF VARIOUS EMBODIMENTS OF THE DISCLOSURE

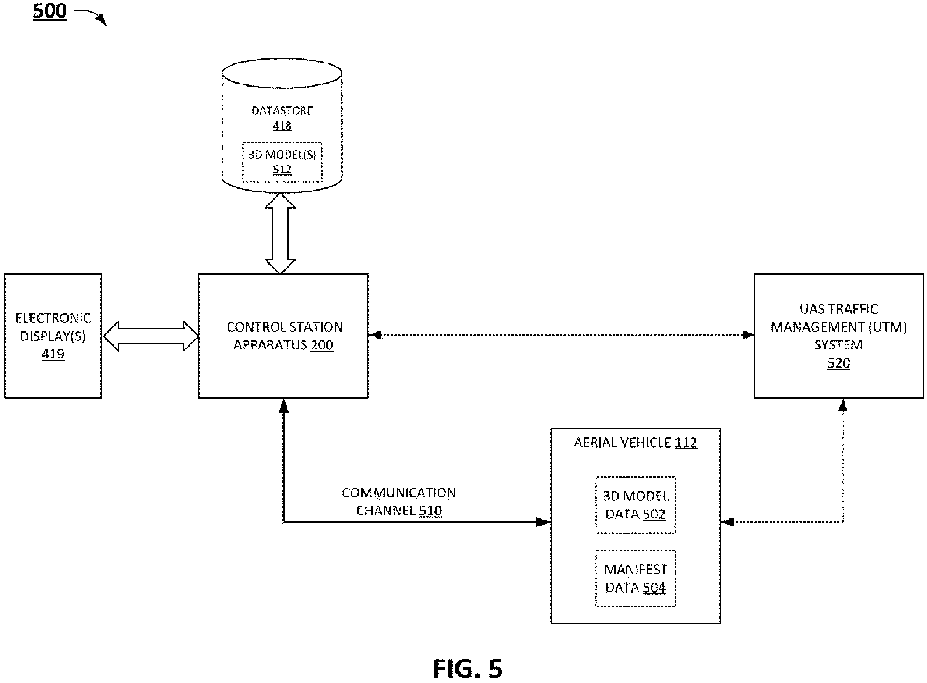

FIG. 5 illustrates an example system 500 configured for 3D model augmentation related to an aerial vehicle in accordance with at least some example embodiments of the present disclosure. The system 500 includes the control station apparatus 200. The control station apparatus 200 can be communicatively coupled to the aerial vehicle 112 and the one or more electronic displays 419 to provide a visually augmented version of a 3D model for the aerial vehicle 112. In some embodiments, the control station apparatus 200 and/or the aerial vehicle 112 can be additionally communicatively coupled to an unmanned aerial systems (UAS) traffic management (UTM) system 520 to further improve visual augmentation version of the 3D model for the aerial vehicle 112. For example, the UTM system 520 can provide traffic management data related to data exchange protocols, infrastructure, performance requirements, and/or other information related to the aerial vehicle 112.

In various embodiments, the control station apparatus 200 can receive 3D model data 502 from the aerial vehicle 112 via a communication channel 510. The 3D model data 502 can represent a 3D model for the aerial vehicle 112. For example, the 3D model data 502 can be an encoded version of the 3D model for the aerial vehicle 112 and/or various sub-components of the aerial vehicle 112. In various embodiments, the 3D model data 502 can represent respective sub-components of the aerial vehicle 112 via a data model binary format. In some embodiments, the data model binary format can include a STEP-file that represents the respective sub-components of the aerial vehicle 112 via 3D objects. In some embodiments, the data model binary format can include an Initial Graphics Exchange Specification (IGES) file format that represents the respective sub-components of the aerial vehicle 112 via an ASCII-based textual format associated with 3D representations. In various embodiments, the communication channel 510 can be a communication channel (e.g., a wireless communication channel) of the network 110. In various embodiments, the communication channel 510 can be a data-link (e.g., a controller pilot data link) of the network 110. Alternatively, in some embodiments, one or more portions of the 3D model data 502 can be determined based on one or more 3D models 512 stored in the datastore 418.

Additionally or alternatively, the control station apparatus 200 can receive manifest data 504 from the aerial vehicle 112 via the communication channel 510. The manifest data 504 can include a manifest data structure related to the 3D model data 502. For example, the manifest data 504 can include a manifest data structure configured in a parameterized format for respective sub-components of the aerial vehicle 112. Additionally, the manifest data structure can link telemetry data (e.g., telemetry parameters) for the aerial vehicle 112 to respective portions of the 3D model data 502 for the aerial vehicle 112. In various embodiments, the control station apparatus 200 can receive the 3D model data 502 and/or the manifest data 504 from the aerial vehicle 112 in response to establishment of a communication connection between the aerial vehicle 112 and the control station apparatus 200 (e.g., the control station system 106) via the communication channel 510. For example, in certain embodiments, the control station apparatus 200 can receive the 3D model data 502 and/or the manifest data 504 from the aerial vehicle 112 during a single communication data exchange between the aerial vehicle 112 and the control station apparatus 200, rather than periodically with telemetry data for the aerial vehicle 112 in order to minimize bandwidth usage between the aerial vehicle 112 and the control station apparatus 200. In some embodiments, the control station apparatus 200 can initially receive a medium or low fidelity version of the 3D model data 502 based on bandwidth conditions of the communication channel 510. For example, the control station apparatus 200 can initially receive a medium or low fidelity version of the 3D model data 502 based on datalink bandwidth conditions between the control station apparatus 200 (e.g., the control station system 106) and the aerial vehicle 112. Additionally, the control station apparatus 200 can subsequently a higher fidelity version of the 3D model data 502 in response to a certain degree of increase for the communication channel 510.

In various embodiments, the control station apparatus 200 can generate a visually augmented version of the 3D model data 502 for the aerial vehicle 112 based on real-time telemetry data for the aerial vehicle 112 that is correlated with the respective portions of the 3D model data 502. The visually augmented version of the 3D model data 502 can emphasize at least one particular respective portion of the 3D model based on the real-time telemetry data. Additionally or alternatively, the visually augmented version of the 3D model data 502 can provide dynamic visual indicators that alter depiction of the respective sub-components of the aerial vehicle 112 based on the real-time telemetry data. For example, the visually augmented version of the 3D model data 502 can recreate a visual likeness of the aerial vehicle 112 and/or various sub-components of the aerial vehicle 112 by augmenting a 3D model with the real-time telemetry data to provide real-time system status information for the aerial vehicle 112 in a human-interpretable format. In various embodiments, the visually augmented version of the 3D model data 502 can provide the dynamic visual indicators as a particular color change, a highlight, a glow, or an icon that alters depiction of the respective sub-components of the aerial vehicle 112 based on the real-time telemetry data. In some embodiments, the visually augmented version of the 3D model data 502 can be stored as a 3D model of the one or more 3D models 512 in the datastore 418. Additionally or alternatively, the control station apparatus 200 can cause a rendering of the visually augmented version of the 3D model data 502 via the one or more electronic displays 419.

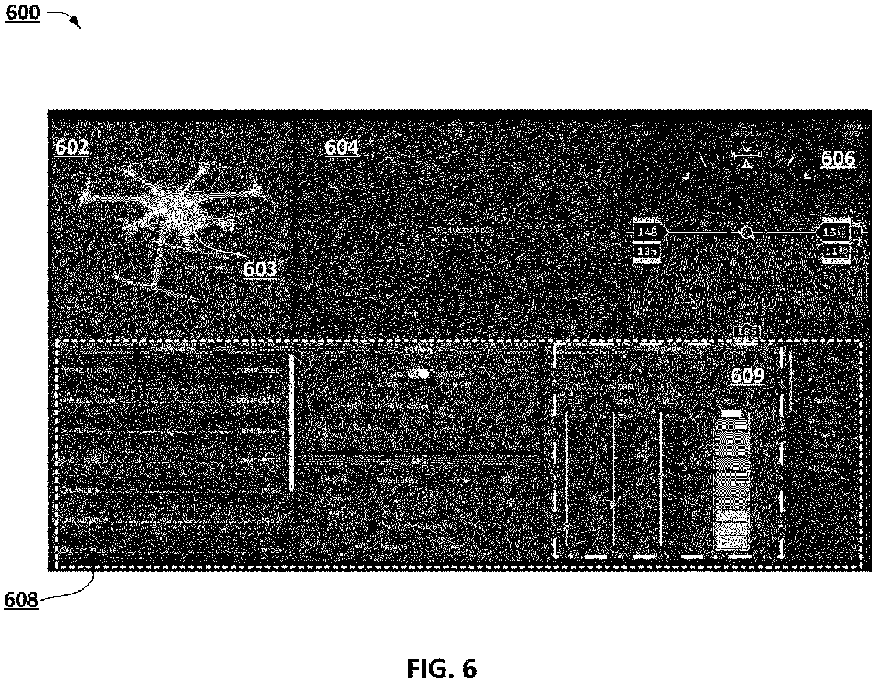

FIG. 6 illustrates an operational example of an electronic display configured to display one or more graphical interfaces related to information for an aerial vehicle in accordance with at least some example embodiments of the present disclosure. Specifically, FIG. 6 illustrates a configuration of an electronic display 600. In various embodiments, the electronic display 600 can be rendered via one or more electronic displays associated with the control station system 106 and/or the remote operations center 414. For example, the electronic display 600 can be rendered via the one or more electronic displays 419. In some embodiments, the electronic display 600 can be rendered via a computer, a smart phone, a laptop, a tablet, a virtual reality device, an augmented reality device, or another type of computing device. Additionally or alternatively, the electronic display 600 can be rendered via one or more electronic displays associated with the aerial vehicle 112 (e.g., electronic displays 408). In certain embodiments, the electronic display 600 may be an electronic display associated with one or more of a PFD, a VSD, an FMS, and/or another type of display.

As shown in FIG. 6, the electronic display 600 is configured to display a plurality of interface elements associated with a flight plan being executed by an aerial vehicle such as the aerial vehicle 112. The electronic display 600 is divided into a 3D model visualization 602, a camera feed view 604, a PFD 606, and/or a system status view 608 related to aerial vehicle 112. The 3D model visualization 602 can provide a rendering of a visually augmented version of a 3D model of the aerial vehicle 112. In various embodiments, the 3D model visualization 602 can include at least one dynamic visual indicator 603 for a component (e.g., a sub-component) of the aerial vehicle 112. The dynamic visual indicator 603 can include a particular color change, a highlight, a glow, or an icon that alters depiction of the respective component (e.g., sub-component) of the aerial vehicle 112 based on real-time telemetry data for the aerial vehicle 112. In a non-limiting example, the dynamic visual indicator 603 can include a yellow visual indicator to indicate that a battery of the aerial vehicle 112 corresponds to a low battery condition.

In various embodiments, the 3D model for the aerial vehicle 112 can be interactively accessed via the 3D model visualization 602. Additionally, a view of the 3D model via the 3D model visualization 602 can be dynamically modified based on user input via the electronic display 600. For example, to highlight and/or obtain additional information regarding a particular sub-component of the aerial vehicle 112, a user can interactively access the 3D model visualization 602 to zoom the view into the particular sub-component and/or to obtain additional real-time data regarding the particular sub-component of the aerial vehicle 112. In some examples, selecting the particular sub-component portion of the 3D model via the 3D model visualization 602 can highlight the particular sub-component portion of the 3D model and/or result in obtaining additional real-time data (e.g., a real-time status, a real-time temperature, real-time electrical measurements, etc.) for the particular sub-component of the aerial vehicle 112. In various embodiments, the relationship between the sub-component portion of the 3D model and the physical sub-component of the aerial vehicle 112 can be realized via a manifest data structure and/or 3D model data provided by the aerial vehicle 112.

The camera feed view 604 can provide a real-time camera view related to flight of the aerial vehicle 112. The PFD 606 can be a primary flight display of the aerial vehicle 112 that provides a view for depicting waypoints, designated locations, flight path data, and/or other flight information related to the aerial vehicle 112. Additionally or alternatively, the PFD 606 can provide a horizontal distance scale view for depicting a profile or side view of terrain, flight path data, and/or other flight information related to the aerial vehicle 112.

The system status view 608 can provide a real-time status for one or more systems and/or components of the aerial vehicle 112. For example, the system status view 608 can provide information related to checklists, communication channel links, location (e.g., GPS), batteries, engines, motors, processors, and/or other systems and/or components of the aerial vehicle 112. Additionally, the system status view 608 can provide a systems health display related to the respective sub-components of the aerial vehicle 112. In some embodiments, the system status view 608 can provide a system status view 609 related to the dynamic visual indicator 603 for the 3D model visualization 602. For example, the system status view 609 can provide additional information related to dynamic visual indicator 603 for the component (e.g., sub-component) of the 3D model provided via the 3D model visualization 602. In a non-limiting example, the system status view 609 can provide additional information related to the low battery condition for the battery. The additional information can include an additional dynamic visual indicator for the battery, electrical measurements (e.g., voltage and/or current), temperature, a battery power capacity level, and/or other information related to a real-time status of the battery.

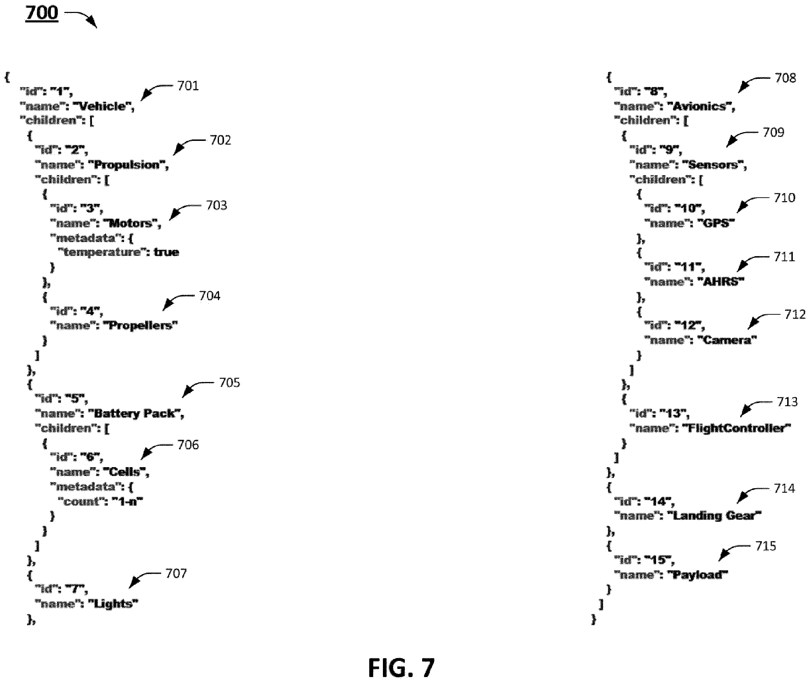

FIG. 7 illustrates an example manifest data structure 700 in accordance with at least some example embodiments of the present disclosure. In various embodiments, the manifest data structure 700 can correspond to the manifest data 504. The manifest data structure 700 can include data indicative of a parameterization of respective sub-components of a vehicle such as, for example, the aerial vehicle 112. For example, the manifest data structure 700 can include a parameterized format for respective sub-components of the aerial vehicle 112 that links telemetry parameters to respective portions of a 3D model for the aerial vehicle 112. In various embodiments, the manifest data structure 700 can correspond to a manifest file that associates sub-components of the aerial vehicle 112 to 3D elements of a 3D model for the aerial vehicle 112. In various embodiments, the manifest data structure 700 can include a vehicle identifier, a component identifier, a 3D model portion identifier, a vehicle name, a component name, a component classification, metadata, component hierarchy information, one or more telemetry data identifiers, and/or other parameterization information for respective sub-components of the aerial vehicle 112.

In a non-limiting example as illustrated in FIG. 7, the manifest data structure 700 includes an identifier 701 related to identification of the aerial vehicle 112, an identifier 702 related to a propulsion sub-component of the aerial vehicle 112, an identifier 703 related to a motor sub-component of the propulsion sub-component of the aerial vehicle 112, an identifier 704 related to a propeller sub-component of the propulsion sub-component of the aerial vehicle 112, an identifier 705 related to a battery pack sub-component of the aerial vehicle 112, an identifier 706 related to a cell sub-component of the battery pack sub-component of the aerial vehicle 112, an identifier 707 related to a lights sub-component of the aerial vehicle 112, an identifier 708 related to an avionics sub-component of the aerial vehicle 112, an identifier 709 related to a sensors sub-component of the avionics sub-component of the aerial vehicle 112, an identifier 710 related to a GPS sub-component of the avionics sub-component of the aerial vehicle 112, an identifier 711 related to an AHRS sub-component of the avionics sub-component of the aerial vehicle 112, an identifier 712 related to a camera sub-component of the avionics sub-component of the aerial vehicle 112, an identifier 713 related to a flight controller sub-component of the aerial vehicle 112, an identifier 714 related to a landing gear sub-component of the aerial vehicle 112, and/or an identifier 715 related to a payload sub-component of the aerial vehicle 112.

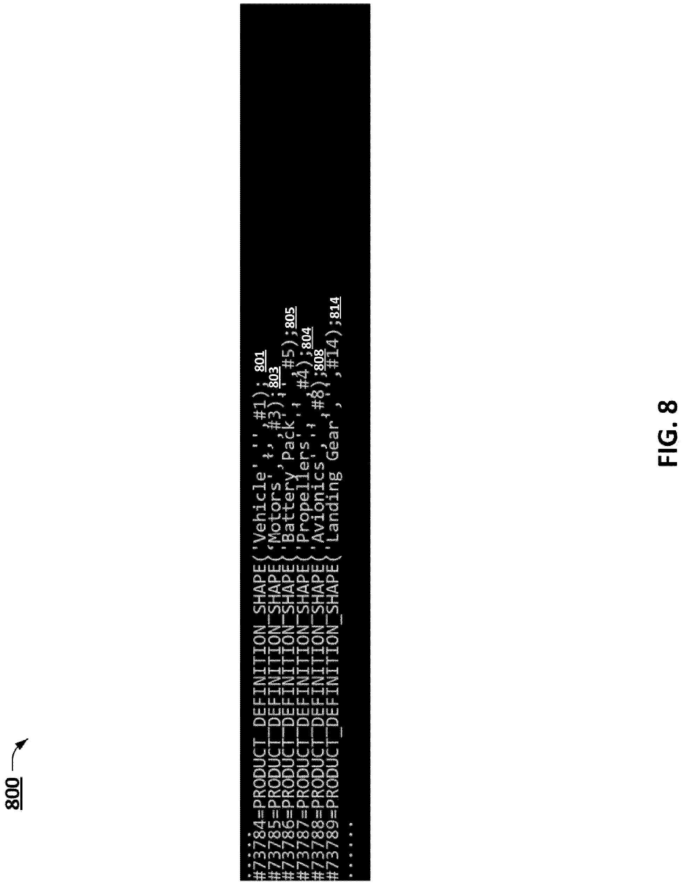

FIG. 8 illustrates example 3D model data 800 in accordance with at least some example embodiments of the present disclosure. In various embodiments, the 3D model data 800 can correspond to the 3D model data 502. The 3D model data 800 can provide a correlation between respective portions of a manifest data structure and a 3D model for a vehicle such as, for example, the aerial vehicle 112. For example, the 3D model data 800 can include a data correlation structure 801 that links the identifier 701 (e.g., the identifier 701 related to identification of the aerial vehicle 112) to an entire 3D model for the aerial vehicle 112, a data correlation structure 803 that links the identifier 703 (e.g., the identifier 703 related to a motor sub-component of the propulsion sub-component of the aerial vehicle 112) to a motor shape portion of the 3D model for the aerial vehicle 112, a data correlation structure 805 that links the identifier 705 (e.g., the identifier 705 related to a battery pack sub-component of the aerial vehicle 112) to a battery pack shape portion of the 3D model for the aerial vehicle 112, a data correlation structure 804 that links the identifier 704 (e.g., the identifier 704 related to a propeller sub-component of the propulsion sub-component of the aerial vehicle 112) to a propeller shape portion of the 3D model for the aerial vehicle 112, a data correlation structure 808 that links the identifier 708 (e.g., the identifier 708 related to related to an avionics sub-component of the aerial vehicle 112) to an avionics shape portion of the 3D model for the aerial vehicle 112, and/or a data correlation structure 814 that links the identifier 714 (e.g., the identifier 714 related to a landing gear sub-component of the aerial vehicle 112) to landing gear shape portion of the 3D model for the aerial vehicle 112.

### EXAMPLE PROCESSES OF THE DISCLOSURE

Having described example systems, apparatuses, data flows, user interfaces, and user interface elements in accordance with the present disclosure, example processes of the disclosure will now be discussed. It will be appreciated that each of the flowcharts depicts an example computer-implemented process that is performable by various means, including one or more of the apparatuses, systems, devices, and/or computer program products described herein, for example utilizing one or more of the specially configured components thereof.

It will be understood that each block of the processes, and combinations of blocks in the flowcharts, may be implemented by various means including hardware and/or a computer program product comprising one or more computer-readable mediums having computer-readable program instructions stored thereon. For example, one or more of the processes described herein in some embodiments is/are embodied by computer program of a computer program product. In this regard, the computer program product(s) that embody the process(es) described herein in some embodiments comprise one or more non-transitory memory devices of a computing device, apparatus, and/or the like (for example, the memory 204 of the control station apparatus 200) storing instructions executable by a processor of a computing device (for example, by the processor 202 of the control station apparatus 200). In some embodiments, the computer program instructions of the computer program product that embody the processes are stored by non-transitory computer-readable storage mediums of a plurality of computing devices. It will be appreciated that any such computer program product(s) may be loaded onto one or more computer(s) and/or other programmable apparatus(es) (for example, the control station apparatus 200), such that the computer program product including the program code instructions that execute on the computer(s) or other programmable apparatus(es) create means for implementing the functions specified in the operational block(s).

Further, in some embodiments, the computer program product includes one or more non-transitory computer-readable memories on which the computer program instructions are stored such that the one or more computer-readable memories can direct one or more computer(s) and/or other programmable apparatus(es) to function in a particular manner, such that the computer program product comprises an article of manufacture that implements the function(s) specified in the operational block(s). Additionally or alternatively, in some embodiments, the computer program instructions of one or more computer program product(s) are loaded onto computing device(s) or other programmable apparatus(es) to cause a series of operations to be performed on the computing device(s) or other programmable apparatus(es) a computer-implemented process such that the instructions that execute on the computing device(s) or other programmable apparatus(es) implement the functions specified in the operational block(s).

Each of the processes depicted includes a plurality of operational blocks defining a particular algorithm for performing one or more portion(s) of functionality for generating and/or outputting improved user interface(s) as described herein. The blocks indicate operations of each process. Such operations may be performed in any of a number of ways, including, without limitation, in the order and manner as depicted and described herein. In some embodiments, one or more blocks of any of the processes described herein occur in-between one or more blocks of another process, before one or more blocks of another process, in parallel with one or more blocks of another process, and/or as a sub-process of a second process. Additionally or alternatively, any of the processes in various embodiments include some or all operational steps described and/or depicted, including one or more optional blocks in some embodiments. With regard to the flowcharts illustrated herein, one or more of the depicted block(s) in some embodiments is/are optional in some, or all, embodiments of the disclosure. Optional blocks are depicted with broken (or "dashed") lines. Similarly, it should be appreciated that one or more of the operations of each flowchart may be combinable, replaceable, and/or otherwise altered as described herein.

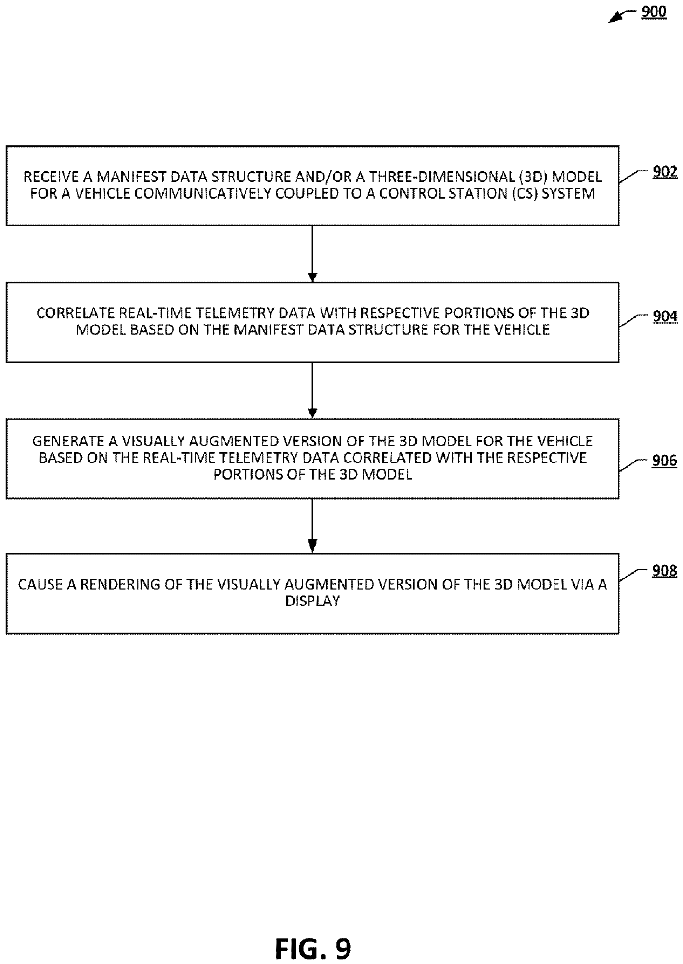

FIG. 9 illustrates a flowchart depicting example operations of an example process for providing augmentation of a 3D model augmentation for an aerial vehicle associated with a flight management platform 400 in accordance with at least some example embodiments of the present disclosure. In certain embodiments, FIG. 9 depicts operations of an example process 900 for augmenting a 3D model for an aerial vehicle with various sub-components whose operation may be impacted by one or more event situations. In some embodiments, the process 900 is embodied by a computer-implemented process executable by any of a myriad of computing device(s), apparatus(es), system(s), and/or the like as described herein. Alternatively or additionally, in some embodiments, the process 900 is embodied by computer program code stored on a non-transitory computer-readable storage medium of a computer program product configured for execution to perform the process as depicted and described.

Alternatively or additionally, in some embodiments, the process 900 is performed by one or more specially configured computing devices, such as the control station apparatus 200 alone or in communication with one or more other component(s), device(s), system(s), and/or the like (e.g., such as the vehicle apparatus 300). In this regard, in some such embodiments, the control station apparatus 200 is specially configured by computer-coded instructions (e.g., computer program instructions) stored thereon, for example in the memory 204 and/or another component depicted and/or described herein and/or otherwise accessible to the control station apparatus 200, for performing the operations as depicted and described. In some embodiments, the control station apparatus 200 is in communication with one or more external apparatus(es), system(s), device(s), and/or the like, to perform one or more of the operations as depicted and described. For example, the control station apparatus 200 in some embodiments is in communication with an end-user computing device, one or more external system(s), and/or the like (e.g., such as the remote operations center 414). It will be appreciated that while the process 900 is described as performed by and from the perspective of the control station apparatus 200for purposes of simplifying the description, the process 900 can also be performed, in total or in part, by the vehicle apparatus 300.

The process 900 begins at operation 902. At operation 902, the control station apparatus 200 includes means such as the processor 202, the memory 204, the input/output circuitry 206, the communications circuitry 208, the 3D modeling circuitry 212, the display circuitry 214, and/or the like, or a combination thereof, that receives a manifest data structure and/or a three-dimensional (3D) model for a vehicle communicatively coupled to a control station (CS) system. In various embodiments, the manifest data structure includes a parameterized format for respective sub-components of the aerial vehicle that links telemetry parameters to respective portions of the 3D model for the vehicle.

At operation 904, the control station apparatus 200 includes means such as the processor 202, the memory 204, the input/output circuitry 206, the communications circuitry 208, the 3D modeling circuitry 212, the display circuitry 214, and/or the like, or a combination thereof, that correlates real-time telemetry data with respective portions of the 3D model based on the manifest data structure for the vehicle.

At operation 906, the control station apparatus 200 includes means such as the processor 202, the memory 204, the input/output circuitry 206, the communications circuitry 208, the 3D modeling circuitry 212, the display circuitry 214, and/or the like, or a combination thereof, that generates a visually augmented version of the 3D model for the vehicle based on the real-time telemetry data correlated with the respective portions of the 3D model. In various embodiments, the visually augmented version of the 3D model emphasizes at least one particular respective portion of the 3D model based on the real-time telemetry data. Additionally or alternatively, in various embodiments, the visually augmented version of the 3D model provides dynamic visual indicators that alter depiction of the respective sub-components of the aerial vehicle based on the real-time telemetry data.

At operation 908, the control station apparatus 200 includes means such as the processor 202, the memory 204, the input/output circuitry 206, the communications circuitry 208, the 3D modeling circuitry 212, the display circuitry 214, and/or the like, or a combination thereof, that causes a rendering of the visually augmented version of the 3D model via a display.

### CONCLUSION

While several example contexts are described herein with respect to processing of data by an aerial vehicle, it will be appreciated in view of this disclosure that embodiments may include or otherwise be implemented as a part of other vehicle(s), device(s), and/or the like. For example, in other contexts, embodiments of the present disclosure utilize sensor(s) of and/or display data to display(s) of other type(s) of vehicle(s), including ground vehicle(s). Alternatively or additionally, some embodiments utilize sensor(s) of and/or display data to display(s) of other device(s), including user device(s), back-end computing device(s), and/or the like. Indeed, in some embodiments, the sensor(s), computing device(s), and/or display(s) are embodied and/or otherwise included in one or more computing device(s) not integrated as part of any vehicle (e.g., as a standalone computing device). In is intended that all such contexts, device type(s), and/or the like be included within the scope of this disclosure and covered within the scope of the claims appended herein.

Although an example processing system is described above, implementations of the subject matter and the functional operations described herein can be implemented in other types of digital electronic circuitry, or in computer software, firmware, or hardware, including the structures disclosed in this specification and their structural equivalents, or in combinations of one or more of them.

Embodiments of the subject matter and the operations described herein can be implemented in digital electronic circuitry, or in computer software, firmware, or hardware, including the structures disclosed in this specification and their structural equivalents, or in combinations of one or more of them. Embodiments of the subject matter described herein can be implemented as one or more computer programs, i.e., one or more modules of computer program instructions, encoded on computer storage medium for execution by, or to control the operation of, information/data processing apparatus. Alternatively, or in addition, the program instructions can be encoded on an artificially generated propagated signal, e.g., a machine-generated electrical, optical, or electromagnetic signal, which is generated to encode information/data for transmission to suitable receiver apparatus for execution by an information/data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially generated propagated signal. The computer storage medium can also be, or be included in, one or more separate physical components or media (e.g., multiple CDs, disks, or other storage devices).

The operations described herein can be implemented as operations performed by an information/data processing apparatus on information/data stored on one or more computer-readable storage devices or received from other sources.

The term "data processing apparatus" encompasses all kinds of apparatus, devices, and machines for processing data, including by way of example a programmable processor, a computer, a system on a chip, or multiple ones, or combinations, of the foregoing. The apparatus can include special purpose logic circuitry, e.g., an FPGA (field programmable gate array) or an ASIC (application-specific integrated circuit). The apparatus can also include, in addition to hardware, code that creates an execution environment for the computer program in question, e.g., code that constitutes processor firmware, a protocol stack, a repository management system, an operating system, a cross-platform runtime environment, a virtual machine, or a combination of one or more of them. The apparatus and execution environment can realize various different computing model infrastructures, such as web services, distributed computing and grid computing infrastructures.

A computer program (also known as a program, software, software application, script, or code) can be written in any form of programming language, including compiled or interpreted languages, declarative or procedural languages, and it can be deployed in any form, including as a stand-alone program or as a module, component, subroutine, object, or other unit suitable for use in a computing environment. A computer program may, but need not, correspond to a file in a file system. A program can be stored in a portion of a file that holds other programs or information/data (e.g., one or more scripts stored in a markup language document), in a single file dedicated to the program in question, or in multiple coordinated files (e.g., files that store one or more modules, sub-programs, or portions of code). A computer program can be deployed to be executed on one computer or on multiple computers that are located at one site or distributed across multiple sites and interconnected by a communication network.

The processes and logic flows described herein can be performed by one or more programmable processors executing one or more computer programs to perform actions by operating on input information/data and generating output. Processors suitable for the execution of a computer program include, by way of example, both general and special purpose microprocessors, and any one or more processors of any kind of digital computer. Generally, a processor will receive instructions and information/data from a read-only memory or a random access memory or both. The essential elements of a computer are a processor for performing actions in accordance with instructions and one or more memory devices for storing instructions and data. Generally, a computer will also include, or be operatively coupled to receive information/data from or transfer information/data to, or both, one or more mass storage devices for storing data, e.g., magnetic, magneto-optical disks, or optical disks. However, a computer need not have such devices. Devices suitable for storing computer program instructions and information/data include all forms of non-volatile memory, media and memory devices, including by way of example semiconductor memory devices, e.g., EPROM, EEPROM, and flash memory devices; magnetic disks, e.g., internal hard disks or removable disks; magneto-optical disks; and CD-ROM and DVD-ROM disks. The processor and the memory can be supplemented by, or incorporated in, special purpose logic circuitry.

To provide for interaction with a user, embodiments of the subject matter described herein can be implemented on a computer having a display device, e.g., a CRT (cathode ray tube) or LCD (liquid crystal display) monitor, for displaying information/data to the user and a keyboard and a pointing device, e.g., a mouse or a trackball, by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser.

Embodiments of the subject matter described herein can be implemented in a computing system that includes a back-end component, e.g., as an information/data server, or that includes a middleware component, e.g., an application server, or that includes a front-end component, e.g., a client computer having a graphical user interface or a web browser through which a user can interact with an implementation of the subject matter described herein, or any combination of one or more such back-end, middleware, or front-end components. The components of the system can be interconnected by any form or medium of digital information/data communication, e.g., a communication network. Examples of communication networks include a local area network ("LAN") and a wide area network ("WAN"), an inter-network (e.g., the Internet), and peer-to-peer networks (e.g., ad hoc peer-to-peer networks).

The computing system can include clients and servers. A client and server are generally remote from each other and typically interact through a communication network. The relationship of client and server arises by virtue of computer programs running on the respective computers and having a client-server relationship to each other. In some embodiments, a server transmits information/data (e.g., an HTML page) to a client device (e.g., for purposes of displaying information/data to and receiving user input from a user interacting with the client device). Information/data generated at the client device (e.g., a result of the user interaction) can be received from the client device at the server.

While this specification contains many specific implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results.

## Claims

1. A computer-implemented method comprising:
receiving (i) a manifest data structure and (ii) a three-dimensional (3D) model for a vehicle communicatively coupled to a control station (CS) system, wherein the manifest data structure comprises a parameterized format for respective sub-components of the vehicle that links telemetry parameters to respective portions of the 3D model for the vehicle;
correlating real-time telemetry data with the respective portions of the 3D model based on the manifest data structure for the vehicle;
generating a visually augmented version of the 3D model for the vehicle based on the real-time telemetry data correlated with the respective portions of the 3D model, wherein the visually augmented version of the 3D model emphasizes at least one particular respective portion of the 3D model based on the real-time telemetry data, and wherein the visually augmented version of the 3D model provides dynamic visual indicators that alter depiction of the respective sub-components of the vehicle based on the real-time telemetry data; and
causing a rendering of the visually augmented version of the 3D model via a display of the CS system.

2. The computer-implemented method of claim 1, further comprising:
receiving the manifest data structure in response to establishment of a communication connection between the vehicle and the CS system.

3. The computer-implemented method of claim 1, further comprising:
receiving an encoded version of the 3D model from the vehicle in response to establishment of a communication connection between the vehicle and the CS system.

4. The computer-implemented method of claim 1, further comprising:
receiving (i) the manifest data structure and (ii) an encoded version of the 3D model from the vehicle in response to establishment of a communication connection between the vehicle and the CS system.

5. The computer-implemented method of any one of claims 1-4, wherein receiving the manifest data structure comprises receiving the manifest data structure from the vehicle in response to establishment of a communication connection between the vehicle and the CS system.

6. The computer-implemented method of any one of claims 1-5, wherein receiving the 3D model comprises receiving the 3D model from the vehicle in response to establishment of a communication connection between the vehicle and the CS system.

7. The computer-implemented method of any one of claims 1-5, wherein receiving the 3D model comprises extracting the 3D model from a datastore communicatively coupled to the CS system based on a vehicle identifier associated with the vehicle.

8. The computer-implemented method of claim 1, further comprising:
initially receiving a first version of the 3D model associated with a particular degree of fidelity based on datalink bandwidth conditions between the CS system and the vehicle; and
subsequently receiving a second version of the 3D model with a higher degree of fidelity in response to a certain degree of increase for the datalink bandwidth availability between the CS system and the vehicle.

9. The computer-implemented method of any one of claims 1-8, wherein the visually augmented version of the 3D model provides the dynamic visual indicators as a particular color change, a highlight, a glow, or an icon that alters depiction of the respective sub-components of the vehicle based on the real-time telemetry data.

10. The computer-implemented method of any one of claims 1-9, wherein the vehicle is an aerial vehicle communicatively coupled to the CS system via a wireless communication channel.

11. A computer program product comprising at least one non-transitory computer-readable storage medium having computer program code stored thereon that, in execution with at least one processor, is configured to:
receive (i) a manifest data structure and (ii) a three-dimensional (3D) model for a vehicle communicatively coupled to a control station (CS) system, wherein the manifest data structure comprises a parameterized format for respective sub-components of the vehicle that links telemetry parameters to respective portions of the 3D model for the vehicle;
correlate real-time telemetry data with the respective portions of the 3D model based on the manifest data structure for the vehicle;
generate a visually augmented version of the 3D model for the vehicle based on the real-time telemetry data correlated with the respective portions of the 3D model, wherein the visually augmented version of the 3D model emphasizes at least one particular respective portion of the 3D model based on the real-time telemetry data, and wherein the visually augmented version of the 3D model provides dynamic visual indicators that alter depiction of the respective sub-components of the vehicle based on the real-time telemetry data; and
cause a rendering of the visually augmented version of the 3D model via a display of the CS system.

12. The computer program product of claim 11, wherein the computer program code is further configured to:
receive the manifest data structure in response to establishment of a communication connection between the vehicle and the CS system.

13. The computer program product of claim 11, wherein the computer program code is further configured to:
receive an encoded version of the 3D model from the vehicle in response to establishment of a communication connection between the vehicle and the CS system.

14. The computer program product of claim 11, wherein the computer program code is further configured to:
receive (i) the manifest data structure and (ii) an encoded version of the 3D model from the vehicle in response to establishment of a communication connection between the vehicle and the CS system.

15. The computer program product of claim 11, wherein the computer program code is further configured to:
initially receive a first version of the 3D model associated with a particular degree of fidelity based on datalink bandwidth conditions between the CS system and the vehicle; and
subsequently receive a second version of the 3D model with a higher degree of fidelity in response to a certain degree of increase for the datalink bandwidth availability between the CS system and the vehicle.
